# EUROPÄISCHE PATENTANMELDUNG

(11) **EP 2 230 701 A2**
(43) Veröffentlichungstag der Anmeldung: **22.09.2010**
(21) Anmeldenummer: 10156678.4
(22) Anmeldetag: 16.03.2010
(51) Int. Cl.: H01L 35/30, H01L 35/32

(54) **Thermoelektrische Vorrichtung**

(30) Priorität: 19.03.2009 DE 102009013535; 07.04.2009 DE 102009016363
(71) Anmelder: Behr GmbH & Co. KG, 70469 Stuttgart (DE)
(72) Erfinder: Himmer, Thomas, 73326 Reichenbach (Deggingen) (DE); Brehm, Holger, 71729 Erdmannhausen (DE); Riedel, Rudolf, 75173 Pforzheim (DE); Heckenberger, Thomas, 70771 Leinfelden-Echterdingen (DE)
(74) Vertreter: Grauel, Andreas

(57) **Zusammenfassung**

Die vorlegende Erfindung betrifft eine thermoelektrische Vorrichtung (1) zur Erzeugung von elektrischer Energie aus Wärme, wobei die Vorrichtung (1) ein thermoelektrisches Modul (3) aufweist, das eine erste Hauptoberfläche (12, 13) und eine der ersten Hauptoberfläche (12, 13) gegenüberliegende zweite HauptOberfläche (12, 13) aufweist, wobei das thermoelektrische Modul (3) eine Mehrzahl von Elementen (14) mit einem thermoelektrisch aktiven Material aufweist, die sich im Wesentlichen senkrecht zwischen der ersten und der zweiten Hauptoberfläche (12, 13) des thermoelektrischen Moduls (3) erstrecken und die ferner ausgebildet sind, um bei einem thermischem Kontakt mit Medien unterschiedlicher Temperatur eine elektrische Energie bereitzustellen. Ferner umfasst die thermoelektrische Vorrichtung (1) eine Haltestruktur (2, 4, 5, 6, 7), die zur Führung eines warmen und eines kalten Mediums und zur Halterung des thermoelektrischen Moduls (3) ausgebildet ist, wobei die Haltestruktur (2, 4, 5, 6, 7) ferner ausgebildet ist, um das kalte Medium derart zu führen, dass es in thermischen Kontakt mit der ersten Hauptoberfläche (12, 13) tritt und das warme Medium derart zu führen, dass es in thermischen Kontakt mit der zweiten Hauptoberfläche (12, 13) tritt.

## Beschreibung

Die vorliegende Erfindung bezieht sich auf eine thermoelektrische Vorrichtung gemäß Anspruch 1.

Unter einem thermoelektrischen Generator (TEG) wird ein Wärmetauscher verstanden, der mit thermoelektrisch aktivem Material bestückt ist. Wird dieses Material einer Temperaturdifferenz ausgesetzt, erzeugt der TEG elektrische Energie. Die Temperaturdifferenz entsteht im TEG dadurch, dass heiße (z.B. Abgas in einem Fahrzeug) und kalte Medien (z.B. Kühlmitel in einem Fahrzeug) aneinander vorbeigeführt werden.

Die Druckschriften EP 000001230475B1, EP 000001475532A2, WO 2007026432, JP000010281015AA, JP002000282960AA, JP 002004068608AA, JP 002005083251AA oder JP002005117836AA offenbaren zwar Ansätze unter Verwendung eines solchen TEG, jedoch sind diese Anwendungen wenig effizient auf Grund nachteiliger Anbindung der thermoelektrischen Module an einen Wärmetauscher.

Es ist die Aufgabe der vorliegenden Erfindung eine verbesserte thermoelektrische Vorrichtung zu schaffen, die eine Erzeugung von elektrischer Energie aus Wärmeenergie ermöglicht, Vorteilhafte Ausgestaltungen der thermoelektrischen Vorrichtung werden durch die Unteransprüche definiert.

Diese Aufgabe wird durch eine thermoelektrische Vorrichtung gemäß Anspruch 1 gelöst.

Die vorliegende Erfindung schafft eine thermoelektrische Vorrichtung zur Erzeugung von elektrischer Energie aus Wärme, wobei die Vorrichtung die folgenden Merkmale umfasst:
- ein thermoelektrisches Modul, das eine erste Hauptoberfläche und eine der ersten Hauptoberfläche gegenüberliegende zweite Hauptoberfläche aufweist, wobei das thermoelektrische Modul eine Mehrzahl von Elementen mit einem thermoelektrisch aktiven Material aufweist, die sich im Wesentlichen senkrecht zwischen der ersten und der zweiten Hauptoberfläche des thermoelektrischen Moduls erstrecken und die ferner ausgebildet sind, um bei einem thermischem Kontakt mit Medien unterschiedlicher Temperatur eine elektrische Energie bereitzustellen; und
- eine Haltestruktur, die zur Führung eines warmen und eines kalten Mediums und zur Halterung des thermoelektrischen Moduls ausgebildet ist, wobei die Haltestruktur ferner ausgebildet ist, um das kalte Medium derart zu führen, dass es in thermischen Kontakt mit der ersten Hauptoberfläche tritt und das warme Medium derart zu führen, dass es in thermischen Kontakt mit der zweiten Hauptoberfläche tritt.

Der vorliegenden Erfindung liegt die Erkenntnis zugrunde, dass die thermoelektrischen Materialien in dem thermoelektrischen Modul optimal in dem Wärmestrom zwischen dem warmen und dem kalten Medium ausgerichtet sind, wenn sie im Wesentlichen senkrecht zu den Hauptoberfiächen des thermoelektrischen Moduls positioniert sind. Als hauptoberflächen des thermoelektrischen Moduls werden dabei die Oberflächenseitendes thermoelektrischen Moduls betrachtet, die gegenüber anderen Oberflächenseiten des thermoelektrischen Moduls mit Abstand am größten sind. Zusätzlich wird durch die Haltestruktur sichergestellt, dass eine thermische Kontaktierung des thermoelektrischen Moduls über die Hauptoberflächen erfolgt, so dass eine sehr große Wärmeaustauschfläche zur Übertragung der Wärme an die Elemente mit dem thermoelektrischen Material besteht, wobei eine optimale Ausrichtung dieser Elemente zur Energieerzeugung besteht.

Die vorliegende Erfindung bietet den Vorteil, dass durch die Kontaktierung Über die Hauptoberflächen des thermoelektrischen Moduls eine gegenüber dem Stand der Technik deutliche bessere thermische Kontaktierung und damit eine deutlich bessere Ausnutzung des thermoelektrischen Effektes für die zur Verfügung stehenden Wärme möglich wird. Zugleich kann die Erfindung technisch einfach ungesetzt werden, da im Wesentlichen lediglich eine günstige Anordnung der thermoelektrischen Materialien und eine einfache Haltekonstruktion zur Führung der Medien mit unterschiedlicher Temperatur vorzusehen sind.

In einer günstigen Ausführungsform der Erfindung kann das thermoelektrische Modul einen Hüllkörper umfassen, der ausgebildet ist, um die Elemente aus dem thermoelektrischen Material gegen Einflüsse oder Verunreinigungen von außerhalb des thermoelektrischen Elements zu schützen, wobei die erste und zweite Hauptoberfläche durch Flächen des Hüllkörpers gebildet werden. Eine solche Ausführungsform der Erfindung bietet den Vorteil, dass das thermoelektrische Modul optimal gegen Umweklteinflüsse, insbesondere fluidische Umwelteinflüsse, geschützt ist und auch die Positionierung der einzelnen thermoelektrischen Materialien gesichert ist.

Auch kann das thermoelektrische Modul zumindest ein Anschlusselement aufweisen, das von einer Oberfläche des thermoelektrischen Moduls absteht und das ausgebildet ist, um eine mechanische Verbindung zwischen dem thermoelektrischen Modul und der Haltestruktur zu verbessern. Ein derart ausgestaltetes thermoelektrisches Modul weist eine sehr gute Befestigungsmöglichkeit an der Haltestruktur auf, wodurch eine hohe Lebensdauer der thermoelektrischen Vorrichtung bei sehr guten gleichbleibendem Wirkungsgrad möglich wird.

Ferner kann auch die erste und/oder zweite Hauptoberfläche eine Profilierung aufweisen. Dies ermöglicht eine Turbulenzblidung beispielsweise beim Überströmen der entsprechenden Hauptoberflächen des thermoelektrischen Moduls durch eines der Medien, so dass eine optimale Wärme- bzw. Kälteübertragung von dem entsprechenden Medium an das thermoelektrische Modul möglich wird.

Auch kann die Trägerstruktur zumindest ein Rohr aufweisen, das zur Führung eines der Medien, insbesondere des warmen Mediums ausgebildet ist, wobei die erste oder zweite Hauptoberfläche dos thermoelektrischen Moduls mit dem Medium in dem Rohr thermisch kontaktierbar ist. Auf diese Weise kann vorteilhaft eine möglichst große Fläche zur Wärme- bzw. Kälteübertragung von dem warmen bzw. kalten Medium an das thermoelektrische Modul genutzt werden.

Um eine weitere Verbesserung der Wärmeübertragung zu ermöglichen, kann in dem Rohr oder um das Rohr herum eine Turbulenzeinlage angeordnet sein und/oder das Rohr an einer Außenseite und/oder an einer Innenseite der Wand des Rohres eine Profilierung aufweisen.

Günstig ist es auch, wenn das Rohr zumindest eine Öffnung aufweist, und wobei ein thermoelektrisches Modul derart angeordnet ist, dass die Öffnung durch das thermoelektrische Modul im Wesentlichen verschossen oder zumindest abgedeckt ist. Hierdurch ist es möglich, dass das warme oder kalte Medium direkt die erste oder zweite Hauptoberfläche berührt, wodurch die Wärme einen deutlich geringeren Wärmeübergangswiderstand braucht, als wenn die Wärme über ein weiteres Medium wie eine Rohrwand geleitet werden müsste.

Auch kann das Rohr ein Flachrohr sein und die Breite der Öffnung näherungsweise der Breite des Flachrohres entsprechen, insbesondere zumindest achtzig Prozent der Breite des Flachrohres entsprechen. Dies stellt sicher, dass ein möglichst großer Teil der Innenseite des Rohres durch eine der Hauptoberflächen des thermoelektrischen Moduls ausgekleidet ist, so dass das Medium in dem Rohr eine möglichst große Kontaktfläche zu dem thermischen Modul "sieht". Dies begünstigt eine hohe Wärmeübertragungsrate.

Um eine möglichst kompakte Bauform der thermoelektrischen Vorrichtung zu erreichen, kann das Flachrohr an zwei gegenüberliegenden größeren (Breit-) Seiten des Fhachrohres zumindest je eine Öffnung die durch je ein thermoelektrisches Modul im Wesentlichen verschlossen oder zumindest abgedeckt sind. Hierdurch kann auf kleinem Raum eine möglichst große Anzahl von thermoelektrischen Modulen in Kombination mit dem Rohr verbaut werden.

Ferner kann eine bessere Turbulenz und damit eine höheren Wärmeaustauschmoglichkeit eines strömenden Mediums im Bereich des thermoelektrisehen Moduls sichergestellt werden, wenn das an dem Rohr befestigte thermoelektrische Modul einen Strömungsquerschnitt für ein in dem Rohr oder ein um das Rohr herum strömendes Medium vergrößert oder verkleinert.

Um eine sehr gute und damit stabile Befestigung des thermoelektrischen Elementes an dem Rohr sicherzustellen, kann das Rohr zumindest einen Durchzug, einen Kragen, eine Sicke oder ein Fügeblech zur Befestigung des thermoelektrischen Moduls daran aufweisen.

Ein Toleranzausgleich durch thermisch bedingte Materiaibewegungen während des Betriebs der thermoelektrischen Vorrichtung kann dadurch ermöglicht werden, dass das Rohr oder ein Fügeblech zumindest eine Prägung, eine Faltung, eine Biegung oder eine Sicke aufweist.

Um eine möglichst gute Wärmeubeftragung sicherzustellen, kann die HalteStruktur ein Gehäuse umfassen, wobei in dem Gehäuse das zumindest eine Rohr derart angeordnet ist, dass in dem Rohr das ein erstes (insbesondere das warme) Medium führbar ist und zwischen einer Außenwand des zumindest einen Rohres und einer Innenwand des Gehäuses ein zweites (insbesondere das kalte) Medium führbar ist. Dies ermöglicht, dass beispielsweise das kalte Medium frei um die Rohre herum fließen kann, so dass in dem Gehäuse eine möglichst große Temperaturdifferenz um das oder die thermoelektrische(n) Modul(e) herum herrscht, wodurch eine hohe elektrische Energieausbeute durch diese bereitgestellt werden kann.

In einer weiteren der vorliegenden Erfindung kann die Haltestruktur ferner einen Diffusor aufweisen, der an dem Gehäuse befestigt ist und der ausgebildet ist, um das in dem Rohr führbare Medium zu sammeln und in das zumindest eine Rohr einzuleiten oder aus dem Rohr auszuleiten. Dies ermöglicht eine gute Verteilung der durch das Rohr führbaren Medien, so dass die im Gehäuse angeordneten Rohre möglichst gleichmaßig von dem Medium durchströmt werden. Dies begünstigt eine möglichst optimale Ausnutzung des zur Verfügung stehenden Wärmeunterschieds zwischen den beiden Medien.

Auch kann die Haltestruktur eine Umlenkung aufweisen die ausgebildet ist, um einen Fluss des kalten Mediums an einer Wand des Rohres umzulenken, Dies bietet den Vorteil, dass das kalte Medium über einen sehr großen Bereich der Fläche des Rohres oder des thermoelektrischen Moduls strömt, so dass eine große Wärmeübertragungsfläche überstrichen wird. Dies ermöglicht eine gute Ausnutzung der vorhandenen Wärme in elektrische Energie.

Bevorzugte Ausführungsbeispiele der vorliegende Erfindung werden nachfolgend Bezug nehmend auf die beiliegenden Zeichnungen näher erläutert, Es zeigen:
- Fig. 1: eine Darstellung eines Ausführungsbeispiels eines thermoelektrischen Generators (TEG) in isometrisch geschnittener Darstellung;
- Fig. 2: eine allgemeine Skizze eines thermoelektrischen Moduls (TEM) im Querschnitt;
- Fig. 3: eine allgemeine Skizze eines TEM-Hüllkörpers im Querschnitt;
- Fig. 4: eine Außenansicht des TEM in isometrischer Darstellung;
- Fig. 5: eine Querschnittsdarstellung eines TEM mit Randerhöhung
- Fig. 6: eine Querschnittsdarstellung eines TEM mit Rand-Absatz;
- Fig. 7: eine isometrische Außenansicht eines TEM mit beispielhafter Profilierung;
- Fig. 8: eine isometrische Außenansicht eines Rohres mit Öffnungen, beispielhaft mit Öffnungen oben und unten
- Fig. 9: eine isometrisch geschnittene Außenansicht eines Rohres mit TEM, beispielhaft Öffnungen mit Durchzug;
- Fig. 10: eine Querschnittsdarstellung von Öffnungen des Rohres mit Durchzug und eingelegtem TEM;
- Fig. 11: eine Querschnittsdarstellung von Öffnungen des Rohres mit Durchzug und Kragen) und eingelegter TEM;
- Fig. 12: eine Querschnittsdarstellung von Öffnungen des Rohres mit Durchzug und Sicke und eingelegtem TFM;
- Fig. 13: Querschnittsdarstellungen von Öffnungen des Rohres und aufgesetztes TEM;
- Fig. 14: eine Querschnittsdarstellung von Öffnungen des Rohres und eingesetztem TEM mit Fügeblech;
- Fig. 15: eine Querschnittsdarstellung von Öffnungen des Rohres und aufgesetztem TEM mit Fügeblech;
- Fig. 16: eine Querschnittsdarstellung von Öffnungen des Rohres und eingesetztem TEM mit Fügeblechen;
- Fig. 17: Darstellungen von Prägungen, Faltungen, Biegungen oder Sicken im Rohr oder im Fügeblech;
- Fig. 18: Querschnittsdarstellungen von Öffnungen des Rohres und einem eingesetzten TEM mit zweiteiligem, schweißbaren Hüllkörper;
- Fig. 19: eine isometrische Bodenansicht;
- Fig. 20: eine isometrische Gehäuseansicht;
- Fig. 21: eine isometrische Ansicht von Turbulenzeinlagen;
- Fig. 22: eine Querschnittsdarstellung eines ersten alternativen Ausführungsbeispiels der vorliegenden Erfindung;
- Fig. 23: eine isometrische Darstellung eines zweiten alternativen Ausführungsbeispiels der vorliegenden Erfindung;
- Fig. 24: eine Seitenansicht eines dritten alternativen Ausführungsbeispiels der vorliegenden Erfindung;
- Fig. 25a-b: eine Querschnittsdarstellung eines vierten alternativen Ausführungsbeispiels der vorliegenden Erfindung, bei der Öffnungen des Rohres und ein eingesetztes TEM dargestellt sind;
- Fig. 26a-d: Querschnittdarstellungen von verschiedenartigen Formen eines fünften alternativen Ausführungsbeispiels der vorliegenden Erfindung von Rohren mit integriertem TEM;
- Fig. 27a: eine isometrische Darstellung eines Gehäuses mit Einprägungen;
- Fig. 27b: eine Vorderansicht eines Gehäuses mit Einprägungen;
- Fig. 28a: eine isometrische Ansicht eines Gehäuses mit Verteiler-Ausprägungen;
- Fig. 28b: eine Querschnittansicht eines TEG-Gehäuses mit Verteiler-Ausprägungen;
- Fig. 29a: eine isometrische Ansicht eines Gehäuses mit Aufweitungen;
- Fig. 29b: eine Querschnittansicht eines TEG-Gehäuses mit Aufweitungen;
- Fig. 30a: eine isometrische Ansicht eines TEG-Blocks mit außenseitigen Umlenkungen;
- Fig. 30b: eine isometrische Ansicht der in Fig. 30a dargestellten außenseitigen Umlenkungen;
- Fig. 31a: eine isometrische Darstellung eines TEM;
- Fig. 31b: eine isometrische Darstellung eines Rohres;
- Fig. 31c: isometrische Darstellung eines Rohres mit TEMl;
- Fig. 32: eine Querschnittdarstellung eines TEM und eines Rohres;
- Fig. 33: eine weitere Querschnittdarstellung eines TEM und eines Rohres;
- Fig. 34: eine weitere Querschnittdarstellung eines TEM und eines Rohres;
- Fig. 35a-b: Darstellungen eines TEM isometrisch im Schnitt und eines isometrischen Ausschnitts eines T-E-aktiven Materials;
- Fig. 36: eine Querschnittsdarstellung eines weiteren Ausführungsbeispiels eines TEM und eines Rohrs;
- Fig. 37: eine Querschnittsdarstellung eines weiteren Ausführungsbeispiels eines TEM, eines Rohrs und einer Seitenschalung;
- Fig. 38a-b: Darstellungen einer Vorsatzschale in isometrischer Ansicht und eines TEG in isometrischer Längsschnittansicht; und
- Fig. 39: isometrische Darstellungen eines TEM mit Profilierung.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei eine wiederholte Beschreibung dieser Elemente weggelassen wird. Ferner werden verschiedene Ausführungsbeispiele beschrieben, wobei einem einschlägigen Fachmann klar ist, dass auch diese Ausführungsbeispiele kombiniert werden können, auch wenn eines solche Kombination hier nicht explizit beschrieben ist.

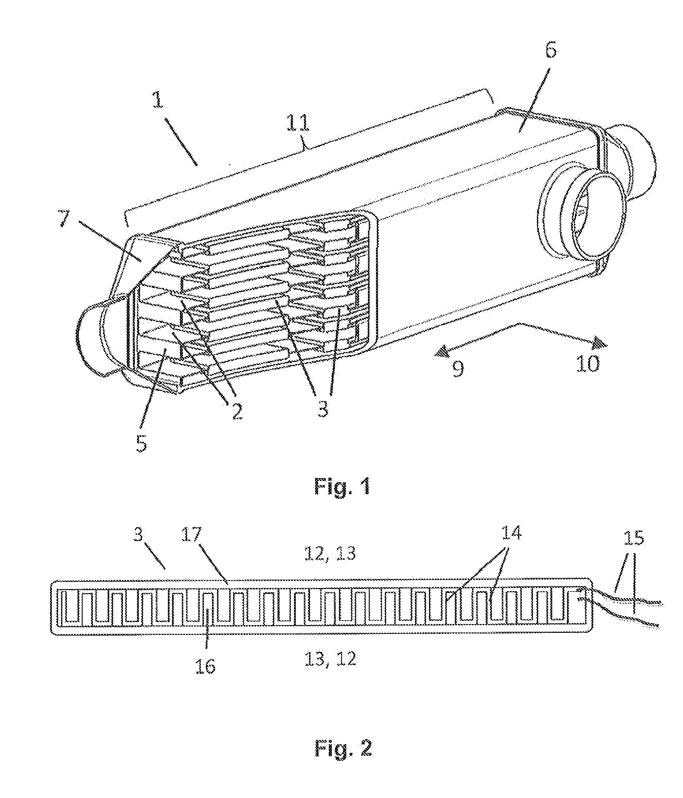

Fig. 1 zeigt eine isometrische Schnittansicht eines ersten Ausführungsbeispiels eines thermoelektrischen Generators 1 (TEG) bzw, einer thermoelektrischen Vorrichtung 1. Der TEG 1 ist in nachfolgender Fig. 1 im Längsschnitt (d.h. in axiale Richtung 9) dargestellt. Seine Bauform stellt aus konstruktiver, thermodynamischer Sicht einen Rohrbündel-Wärmetauscher dar. Anstatt der nachfolgend vielfach angeführten Edelstahl-Materialien können auch andere Metalle wie Aluminium oder Kupfer vorgesehen werden. Des Weiteren sind die nachfolgenden Abbildungen nicht maßstäblich.

Der in Fig. 1 dargestellte TEG 1 besteht im Wesentlichen aus Rohren 2, an denen thermoelektrische Module (TEM) 3 angebracht sind. Ferner können evtl. Fügebleche 4 zur besseren Halterung an den Rohren 2 oder TEM 3 angebracht sein, um eine Verbindung zwischen den Rohren 2 und den TEM 3 zu verbessern. Zusätzlich sind Böden 5 vorgesehen, um zumindest ein Medium in die Rohre zu leiten. Auch können die Rohre 2 in einem Gehäuse 6 angeordnet sein, die Diffusoren oder Sammler 7 aufweisen, um ebenfalls ein Medium zu sammeln und in die Rohre 2 zu leiten. Um eine bessere Turbulenz und damit ein besseres Wärmeübertragungsverhalten sicherzustellen, können evtl. auch Turbulenzeinlagen 8 zwischen den Rohren 2 und dem Gehäuse 6 oder in den Rohren 2 angeordnet sein (was jedoch in Fig. 1 nicht dargestellt ist).

Prinzipiell kann die thermoeiektrische Vorrichtung 1 dazu verwendet werden, um die im Abgas (beispielsweise eines Verbrennungsmotors eines Kraftfahrzeugs) in Form von Wärme gespeicherte Energie besser zu nutzen, die bisher oftmals ungenutzt an die Umgebung abgeführt wird. Um den Wirkungsgrad der Anlage (beispielsweise des Fahrzeugs) zu erhöhen, und folglich den CO₂-Ausstoss im Betrieb zu senken, wird ein TEG 1 implementiert, der einen Teil der Wärme in elektrische Energie umwandelt und diese an die Anlage zurückführt. Der TEG kann mit unterschiedlichem Nutzen an beliebiger Stelle im Abgasstrang oder in der Abgasrückführung untergebracht sein.

Zum allgemeinen Funktionsprinzip eines thermoelektrischen Generators kann folgendes ausgeführt werden. Im TEG 1 werden beispielsweise im Gleich- oder Gegenstrom zwei Medien mit unterschiedlicher Temperatur entlang einer Wärmeübertragungsstrecke 11 aneinander vorbeigeführt, sodass es zu einem Wärmetransport vom warmen zum kalten Medium kommt. Die beiden Medien sind getrennt, sodass es zu keiner Durchmischung kommt. Beim heißen Medium handelt es sich beispielsweise um Abgas, beim kalten Medium beispielsweise um ein Wasser-Glysantin-Gemisch (Kühlmittel). Das Abgas entstammt beispielsweise einem Verbrennungsmotor, das Wasser-Glysantin-Gemisch einem Kühlmittelkreislauf zur Kühlung verschiedener und Motor-, Klimaanlagen-, oder Batteriekomponenten.

Die Erzeugung von elektrischer Energie im TEG kann wir folgt beschrieben werden. In der Trennebene/-fläche zwischen heißem und kaltem Medium im TEG 1 werden thermoelektrische Module 3 (TEM) eingebracht. Das bedeutet, dass eine Seite 12 bzw. 13 des TEM 3 in direktem oder indirektem Kontakt zum heißen Medium steht, und die andere 13 bzw. 12 in direktem oder indirektem Kontakt zum kalten Medium. Die hierdurch anstehende Temperaturdifferenz zwischen der einen und anderen Seite 12, 13 des TEM 3 ruft Thermodiffusionsströme innerhalb der thermoelektrisch aktiven Materialien 14 (z.B. HalbleiterMaterialien) in dem TEM 3 hervor, wodurch eine elektrische Spannung entsteht (dies ist auch Seebeck-Effekt bekannt). Die elektrische Spannung kann in Form von elektrischem Strom abgegriffen werden. Hierzu wird der elektrische Strom über Elektro-Kabel 15, die in das Innere des TEM 16 führen und dort angeschlossen sind einem elektrischen Verbraucher oder einem elektrischen Speicher außerhalb des TEG 1 zugeführt.

Zum innenseiteigen Aufbau 16 eines TEM 3 (beispielsweise gemäß Fig. 2) lässt sich folgendes ausführen: Im TEM 3 wird abwechselnd eine Vielzahl thermoelektrisch aktiver Materialien 14 (z.B. n- und p-dotierte Halbleiter) über elektrische Leiter miteinander verschaltet. Die geometrische Ausrichtung der thermoelektrisch aktiven Materialien 14 weist im Wesentlichen in Richtung des Wärmestroms von der Warm- 12 bzw. 13 zur Kaltseite 13 bzw. 12. Als Werkstoff der thermoelektrisch (TE) -aktiven Materialien kommt beispielsweise PbTe oder BiTe in Frage.

Um die gewünschten elektrischen Spannungen und Stromflüsse einzustellen, können die TEM-internen Halbleiter-Leitermaterialen gleich- oder parallelverschaltet werden. Dies gilt auch für die elektrische Verschaltung der TEM 3 untereinander.

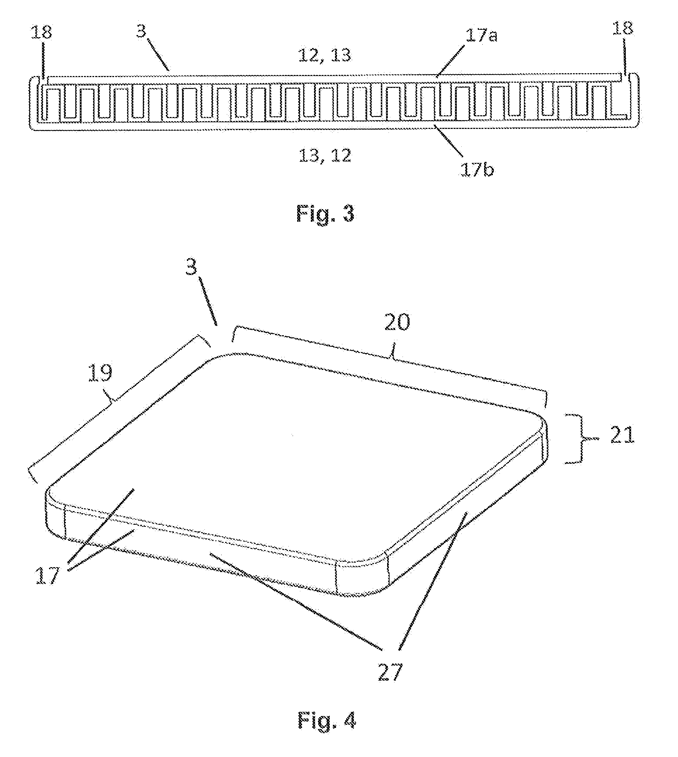

Zu einem möglichen Hüllkörper 17 des TEM 3 (beispielsweise gemäß Fig. 3) lässt sich folgendes ausführen; Die thermoelektrisch aktiven Materialien 14 und die Leitermaterialien sollten nach außen hin 9, 10 elektrisch isoliert werden. Dazu wird das TEM 3 günstigerweise nach allen Seiten 9, 10 von einer elektrisch isolierenden Hüllschicht 17 umgeben. Dieser Hüllkörper 17 ist Teil der TEM 3 und schützt die elektrischen, inneren Komponenten 16 außerdem vor eindringendem Schmutz und vor Feuchtigkeit und ggf, Flüssigkeiten.

Als Hüllkörper-Material 17 kommt beispielsweise ein keramischer Werkstoff zum Einsatz. Der Hüllkörper 17 kann beispielsweise zweiteilig 17a, b aufgebaut werden. Die beiden Teile 17a, b sollten dann zueinander seitlich 27 durch eine Dichtung 18 abgedichtet werden. Dies kann beispielsweise in Form einer Klebung oder Lötung erfolgen. Einer der beiden Hüllkörper-Teile 17a oder b kann auch die Form einer Schale haben(wie es in Fig. 3 gezeigt ist), wobei dann das andere Teil 17a oder b in diese eingelegt wird, sodass man das Abdichten 18 des Hüllkörpers 17 auf die Ober- oder Unterseite 12, 13 verlegen kann. Dies kann bei der weiteren Anbindung des TEM 3 an den Wärmetauscher bzw. den thermoelektrischen Generator 1 vorteilhaft sein.

Denkbar wäre auch eine Hülle aus einem Edelstahl, wobei dann zwischen dem thermoeiektrischen Halbleiter-Leitermaterial und dem Edelstahl zusätzliche eine elektrisch isolierende Schicht eingebracht werden sollte, Diese Schicht könnte beispielsweise eine Kunststoff- oder Natursteinfolie dreidimensional verformbar sein. Auch könnte der Edelstahl-Hüllkörper auf der Innenseite 16 beschichtet sein (z.B. mit einer Keramik-Beschichtung).

Es können verschiedene Ausführungsvarianten der TEM 3 verwendet werden, insbesondere bei einem keramischen bzw. nicht-metallischen Hüllkörper 17:

Im Nachfolgenden wird nicht mehr zwischen ein 17- oder mehrteiligem 17a, b Hüllkörper unterschieden. Die beschriebenen Ausführungen beziehen sich allgemein auf den Hüllkörper 17, und betreffen somit einen ein- oder mehrteiligem Hüllkörper 17a, b gleichermaßen.

Das Äußere 17 des TEM 3, insbesondere also dessen Hullkörper 17, ist hauptsächlich flächig gestaltet und ähnelt einem Blech oder einer Scheibe. Fig. 4 zeigt ein Beispiel für ein derartiges TEM 3. Die Breite 20 und Länge 19 des TEM 3 übersteigt somit im Allgemeinen dessen Höhe 21. Das TEM 3 kann in flächiger Ansicht L x B rund kreisförmig oder oval oder vieleckig Viereck, Sechseck gestaltet sein. In bevorzugter Bauweise entspricht das TEM 3 einem flachen Würfel (siehe Fig. 4), wobei die Ecken auch teilweise stark abgerundet oder angefast sein können.

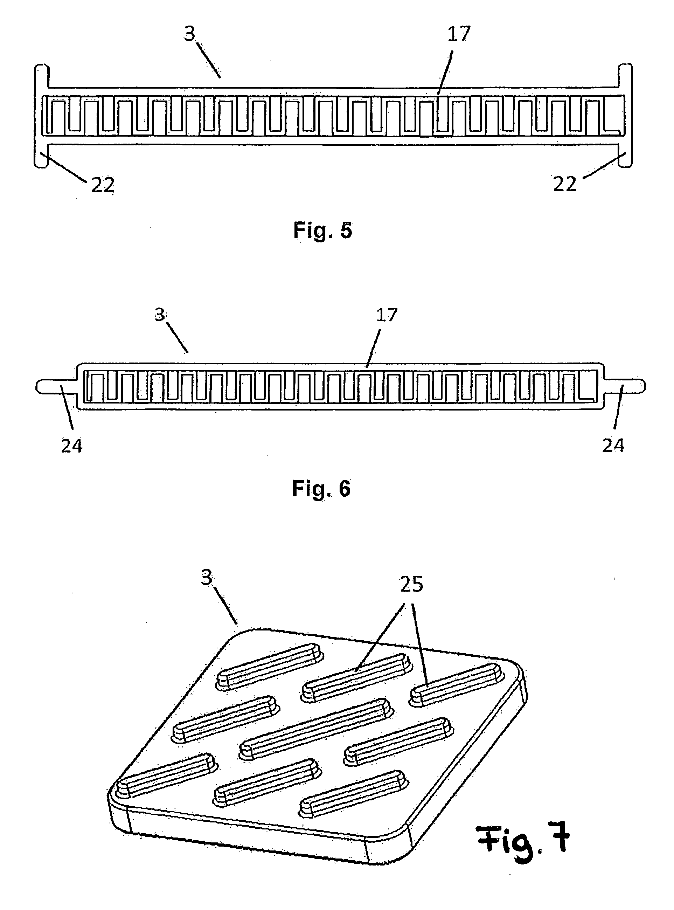

Es können unterschiedliche ausgestalte TEM 3 verwendet werden;
1. Das TEM 3 ist ohne weitere Merkmale ausgeführt.
2. Das TEM 3 kann im Randbereich ein oder beidseitig 12, 13 (beispielweise gemäß Fig. 5) erhöht sein 22, um die wirksamen Verbindungsflächen mit dem Rohr 2, bzw. dessen Durchzüge 23 und/oder mit den Fügeblechen 4 zu erhöhen.
3. Das TEM 3 kann im äußeren Bereich einen ein- oder beidseitigen 12, 13 Absatz 24 aufweisen (beispielsweise entsprechend Fig. 6).
4. Die nach außen führenden Elektro-Kabel 15 des TEM 3 können ober- oder unterseitig 12, 13 oder seitlich 27 angeordnet sein.
5. Um den Wärmübergang zu erhöhen, kann es vorteilhaft sein, das TEM 3 ober- und/oder unterseitig 12, 13 zu profilieren 25 (z.B. durch eine Berippung gemäß Fig. 7). Die Profilierung 25 kann am Hüllkörper 17 durchgeführt oder nachträglich aufgebracht werden.

Der Sonderfall eines metallischen Hüllkörpers 17 eines TEM 3, sowie dessen konstruktive Gestaltung und Einbindung in den TEG 1, wird nachfolgend noch näher beschrieben.

Als nächstes folgen einige Ausführungen zu den Rohren 2. Die Rohre 2 trennen die beiden Stoffströme (d.h. Medien) entlang der Wärmeübertragungsstrecke 11, sprich in radialer Richtung 10.

Die Rohre 2 sind in bevorzugter Weise Hachrohre bzw. Flachkanäle aus einem hochtemperaturbeständigen Edelstahl-Werkstoff. Diese Rohre 2 werden üblicherweise aus einem dünnwandigen Blech hergestellt, wobei das Blech zuerst geschnitten, dann gebogen und abschließend geschweißt werden kann. Prinzipiell sind jedoch auch andere Formen, z.B. die eines Rundrohres oder eines ovalen Rohres denkbar.

In den Rohren 2 wird das heiße oder das kalte Medium entlang der Wärmeübertragungsstrecke 11 geführt. Bevorzugt wird dem Inneren 12 des Rohres 2 die Stoffführung des heißen Mediums zugeordnet, wobei dann das Äußere 13 des Rohres 2 mit dem kalten Medium in thermischem Kontakt steht.

Wie die TEM 3 können auch die Rohre 2 teilweise oder ganz profiliert oder berippt sein (z.B. durch eine Winglet-Struktur). Hierzu weisen die Rohre 2 eine entsprechende innere und/oder äußere Prägestruktur auf. Diese Strukturierung kann sich in dreierlei Hinsicht auf die strömenden Medien auswirken:
A. Aufbrechen der laminaren Grenzschicht
   Die Berippung wird im turbulenten Bereich angeströmt, wodurch sich der Wärmeübergang vom Medium zur Wandung verbessert.
B. Verwirbeln der Strömung
   Die Moleküle des Mediums strömen nicht mehr nur primär eindimensional entlang der Warneübertragungsstreeke, sondern dreidimensional bei einer beispielsweise spiral-förmigen Strömungsform. Die Dicke der laminaren Grenzschicht wird partiell verkleinert. Die Bereiche der Strömung mit max./min. Temperatur werden näher an die Rohrwandung herangeführt. Letztlich verbessert sich auch hierdurch der Wärmeübergang.
C. Vergrößerung der wärmeübertragenden Fläche der Wandung

Die Länge der Rohre 2 entspricht der Wärmeübertragungsstrecke 11 im TEG 1. Der Anfang und das Ende der Rohre 2 stellt den Ein- und Austritt eines Mediums bevorzugt das warme Medium in die Wärmeübertragungsstrecke 11 innerhalb 12 des Rohres 2 dar,

Die Rohre 2 können in beliebiger Anzahl übereinander geschichtet sein. Die Rohre können ebenfalls in beliebiger Anzahl nebeneinander angeordnet sein. Außerhalb 13 der Rohre 2, also zwischen den einzelnen Rohrlagen- und Kolumnen, strömt das andere Medium bevorzugt das kalte Medium, weshalb sich die Rohre 2 gegenseitig nicht berühre brauchen.

Auf der Rohroberfläche können noppenartige, hervorstehende Gebilde eingeprägt sein, die eine gegenseitige Abstützung der Rohre 2 untereinander gewährleisten. An diesen Stellen besteht somit Kontakt zwischen den Rohren 2.

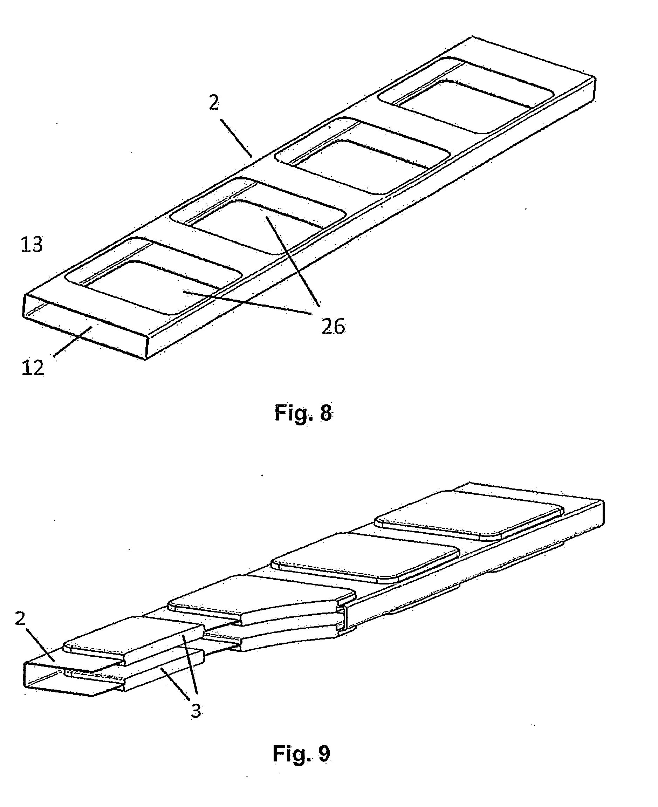

Zum Fügen des Rohres 2 mit der TEM 3 lässt sich folgendes ausführen. Die Wandung der Rohre 2 weist oben und/oder unten, bzw. seitlich liegende Öffnungen/Durchbrüche 26 auf, wie dies beispielhaft in Fig. 8 dargestellt ist. Die oben und unten liegenden Öffnungen 26 werden bevorzugt. In einem Montageschritt werden die Rohre 2 und die TEM 3 zusammengebracht. Die TEM 3 werden hierbei in die Öffnungen 26 ein oder aufgesetzt/eingelegt. Folglich ist die Form der Öffnungen 26 auf die Form der TEM 3 konstruktiv und funktionell abgestimmt.

Je Rohr 2 sind beispielsweise ein oder mehrere Öffnungen vorgesehen. Die Öffnungen können hintereinander und/oder nebeneinander angeordnet sein. In jede der Öffnungen wird ein TEM angebracht. Das heißt die Anzahl und Anordnung der Öffnungen entspricht derjenigen der TEM. In bevorzugter Ausführung sind die Öffnungen entlang des Rohr-Verlaufs hintereinander angeordnet, wobei der Abstand von Öffnung zu Öffnung möglichst klein gehalten wird, und die Breite der Öffnung näherungsweise der Breite des Rohres entspricht, also möglichst breit ist. Beispielsweise befinden sich die Öffnungen auf der Ober- und Unterseite des Rohres gleichermaßen.

Die Rohre 2 sind mit den TEM 3 im Bereich der Öffnungen 26 verbunden wie dies beispielhaft in Fig. 9 dargestellt ist. Die Verbindung wird beispielsweise über eine Klebung oder stoffschlüssig über eine Lötung (z.B. mittels Glasloten) herbeigeführt. Dies gilt insbesondere für die Verwendung von einem nicht-metallischen Werkstoff der TEM-Hülle 17 wie beispielsweise einer Keramik, Bei der Verwendung eines Metalls, sodass sowohl Rohr 2 und TEM-Hülle 17 metallisch sind, kann auch eine Schweißung (z.B. Laser-Schweißung) als Verbindungstechnik vorteilhaft sein.

Um die Effektivität des TEG 1 zu steigern, kann es außerdem vorteilhaft sein, wenn die oberflächigen Bereiche des Rohres 2 auf der einen 12 oder anderen Seite 13, welche nicht mit einem TEM 3 belegt sind, mit einem Wärmedurchgangswiderstand erhöhenden Beschichtung versehen sind oder in geeigneter Weise überdeckt (z.B. zwei-schaliger, miteinander geklippter Kunststoff-Mantel oder überzogen sind.

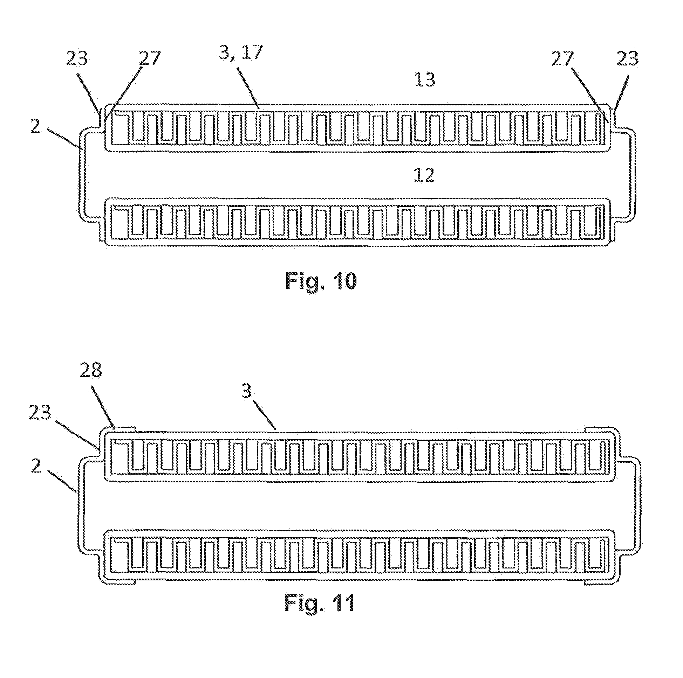

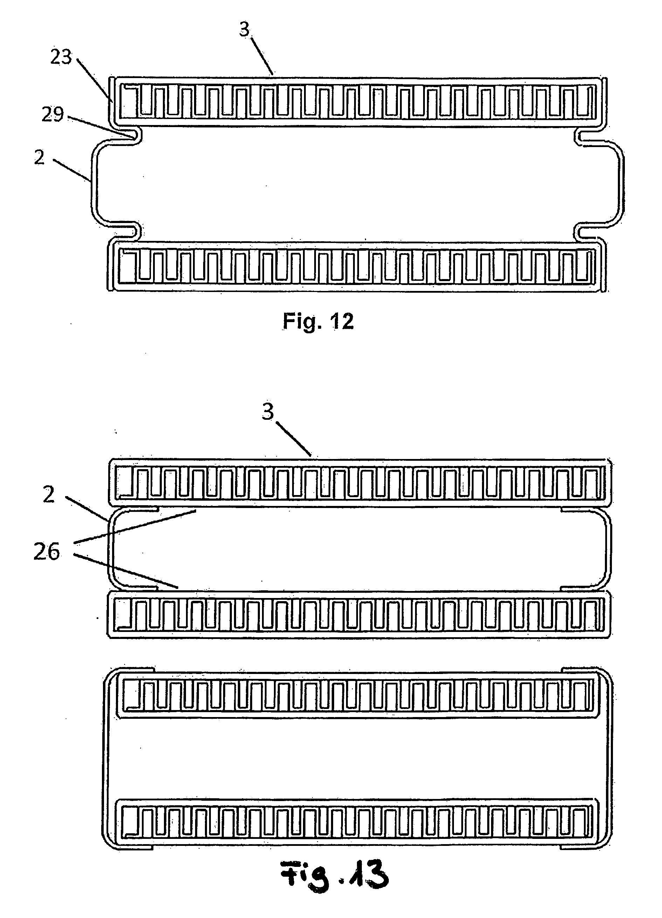

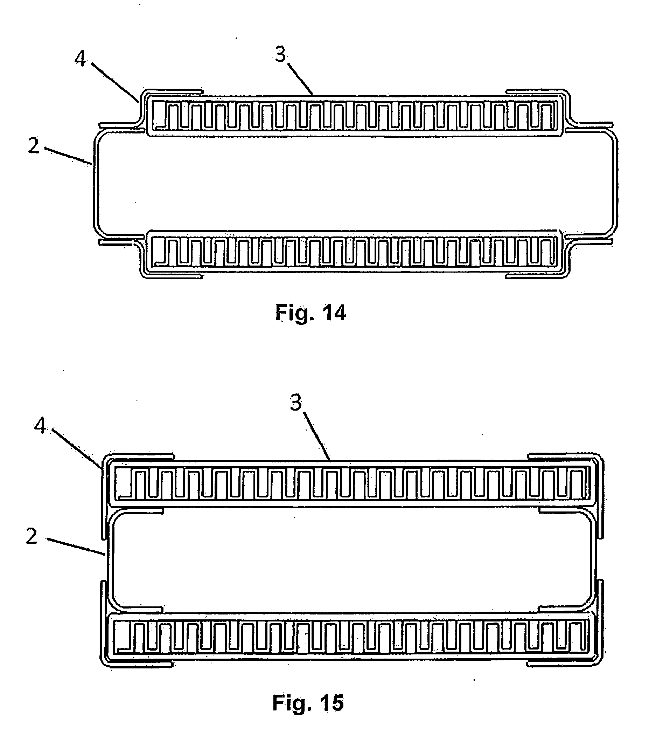

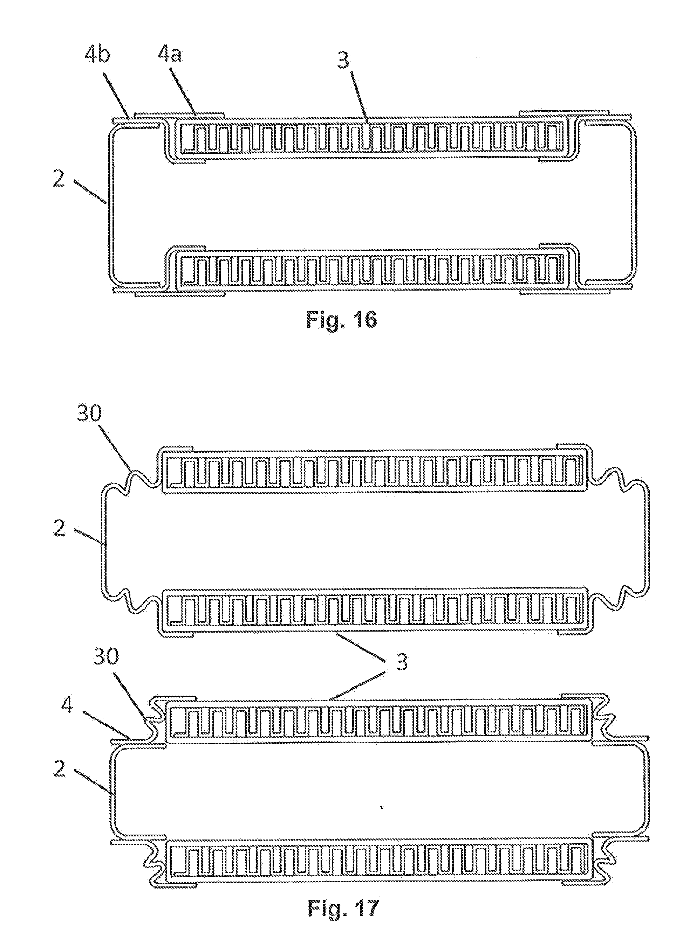

Im Folgenden werden einige Ausführungsvarianten der Öffnungen 26 der Rohre 2 mit einem Verbindungsmechanismus Rohr 2-TEM 3 erläutert.
1. Die Öffnung 26 kann gemäß der Darstellung aus Fig. 10 mit einem Durchzug 23 ausgeführt werden. Der Durchzug 23 kann nach oben 13 und/oder unten 12 weisen. Das TEM 3 wird am Durchzug 23 mit dem Rohr 2 verbunden. Somit ist primär der außenliegende seitliche Bereich 27 des TEM 3 mit dem Rohr-Durchzug 23 verbunden, während die Ober 13- und Unterseite 12 nicht angebunden ist, bzw. größtenteils nicht angebunden ist.
   In der günstigen Ausführungsform wird das Innere 12 des Rohres 2 mit heißem Abgas durchströmt. Dann weisen die Durchzüge 23 beispielsweise nach außen 13. Die Verbindung liegt dann näher dem kalten Medium als dem warmen, weshalb die Verbindung thermisch und thermomechanisch weniger belastet wird.
2. Die Durchzüge 23 aus dem unmittelbar vorausgehenden Absatz 1. können an deren Ende mit einem gebogen Kragen 28 gemäß Fig. 11 versehen sein, um eine zusätzliche Verbindung- und/oder Haltefläche auf der Ober 13- oder Unterseite 12 des TEM 3 zu erhalten, und um ggf. die Montage zu erleichtern.
3. Die Durchzüge 23 aus dem unmittelbar vorausgehenden Absatz 1, können an deren Anfang geknickt sein (beispielsweise mit einer Sicke 29 versehen sein). Der Abstand vom heißen Medium zur Verbindung Durchzug 23-TEM 3 wird vergrößert. Außerdem wird eine thermische Trennung dadurch geschaffen, dass die Verbindungsstelle vom kalten Medium in der Sicke 29 unterspült wird. Im Übrigen wird ggf. die Montage erleichtert. Die Sicke 29 kann zudem als Kompensationselement betrachtet werden um die durch Temperaturunterschiede hervorgerufenen Längenänderungen zu kompensieren oder eine Schwingungsübertragung auf die TEM zu vermeiden.
4. Die Öffnung 26 ist ohne besondere zusätzliche Merkmale ausgeführt. Das TEM 3 wird dann nicht in die Öffnung 26 eingesetzt, sondern (beispielsweise entsprechend der Darstellung aus Fig. 13) auf der Innen 12- oder Außenseite 13 des Rohres 2 im Bereich der Öffnung 26 zentrisch aufgesetzt, wobei dann das TEM 3 breiter 20 und länger 19 sein kann als die Öffnung 26. Das TEM 3 wird an dessen Auflagefläche auf dem Rohr 2 mit diesem verbunden.
5. Das TEM 3 ist im äußeren Bereich umlaufend mit einem Fügeblech 4 verbunden wie es beispielhaft in Fig. 14 dargestellt ist. Die Verbindung kann auf der Ober 13- oder Unterseite 12 und/oder an den Stirnseiten 27 bestehen. Das Fügeblech 4 überragt das TEM 3 nach allen Seiten. Das Fügeblech 4 kann mehrfach gebogen/geknickt sein. Die TEM-Fügeblech-Baugruppe 3, 4 wird in die Öffnung 26 des Rohres 2 eingesetzt. Der das TEM 3 seitlich überragende Bereich des Fügeblechs 4 wird mit dem Rohr 2 verbunden (z.B, durch Laser-Schweißen). Sollte der Rand der TEM 3 erhöht 22 sein, umschließt der verbindende Bereich des Fügeblechs 4 diesen 22.
6. Bei einer Ausführungsvariante gemäß dem unmittelbar vorstehenden Abschnitt 5. braucht das TEM 3 allerdings nicht in die Öffnung 26 des Rohres 2 eingesetzt werden, sondern kann wie im vorausgehenden Abschnitt 4. auf die etwas kleinere Öffnung aufgesetzt werden (siehe Fig. 15).
7. Bei einer Ausführungsvariante gemäß dem unmittelbar vorstehenden Abschnitt 5. kann das TEM 3 jedoch beidseitig 12, 13 mit Fügeblechen 4a, b verbunden werden, wie dies beispielhaft in Fig. 16 dargestellt ist. Die Fügebleche 4a, b können miteinander verbunden sein (z.B. durch Schweißen). Eines oder beide Fügebleche 4a, b werden mit dem Rohr 2 verbunden (z.B. durch Schweißen). Das der heißen Seite zugewandte Fügeblech 4a oder b kann lose bzw. kraftschlüssig auf der TEM 3 aufliegen, sodass zumindest eine thermische Isolationsschicht ("Totwassergebiet") zur Verbindung der TEM 3 mit dem anderen Fügeblech 4a oder b geschaffen wird, Der Zwischenraum der beiden Fügebleche 4a, b stellt dabei die Isolationsschicht dar.
8. In den Fügeblechen 4 und/oder in Bereichen im Rohr 2 neben den Öffnungen 26 können Prägungen, Faltungen, Biegungen oder Sicken 30 entsprechend den Darstefllungen aus Fig. 17 vorgesehen werden, welche die Funktion eines Wellbalgs haben thermisches, thermo-mechanisches und mechanisches Kornpensationselement.

Die vorangegangen beschriebenen Ausführungen beziehen sich primär, aber nicht ausschließlich, auf das Fügen eines TEM 3 mit einem TEM-Hüllkörper 17 der aus einem ein- oder zweiteiligen keramischen Werkstoff besteht, und der nicht mit einem Metall-Blech verschweißt werden kann.

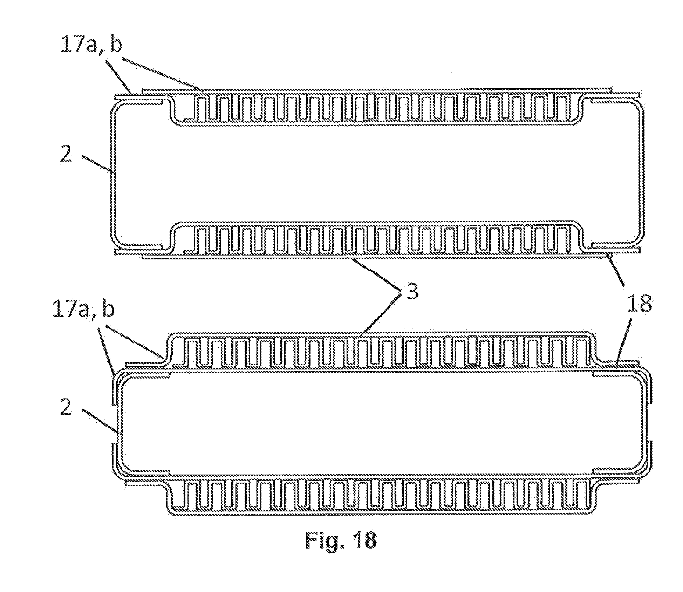

Nachstehend ist eine weitere Ausführungsvariante der vorliegenden Erfindung beschrieben, die in erster Linie auf eine Verschweißung zwischen Rohr 2 und TEM 3 abzielt:
9. Der Hüllkörper 17 des TEM 3 (z,B. Edelstahl) kann ein- oder zweiteilig ausgeführt werden, wie dies in Fig. 18 exemplarisch dargestellt ist. Bei einer zweiteiligen Ausführung kann einer der beiden Hüllkörper-Teile 17a, b die Form einer Schale (entsprechend Fig. 18) haben, wobei dann das andere Teil 17a oder b hierauf aufgesetzt wird. Das Abdichten an der Fügestelle 18 zwischen den beiden 17a, b kann beispielsweise. über eine Schweißung im Seitenbereich 27 herbeigeführt werden. Eines der beiden TEM-Hulltelle 17a oder b wird nachdem das TEM 3 in die Öffnung 26 des Rohres 2 ein- oder aufgesetzt wurde, mit dem Rohr 2 ober- oder unterseitig oder seitlich verschweißt.

Die vorstehend genannten aufgeführten Ausführungsvarianten 1, - 9. können sich bezüglich ihrer genannten Merkmale überlagern bzw. sind kombinierbar, sodass es noch zu weiteren Zwischenvarianten kommen kann.

Es können unterschiedliche Einstecktiefe der TEM 3 in die Öffnung 26 gewähr werden. Das TEM 3 kann in der Form in die Öffnungen 26 des Rohres 2 eingesetzt werden, so dass der äußere 13 oder der innere 12 Strömungsquerchnitt des jeweiligen Mediums penetriert wird (TEM 3 steht hervor). Das bedeutet, dass die Unter- oder Oberseite 12, 13 des TEM 3 die Rohrwandung 2 überragt, denn die Höhe 21 der TEM 3 übersteigt im Allgemeinen die Dicke der Wandung des Rohrs 2.

Auch ist es möglich, dass die TEM 3 in der Form in die Öffnungen 26 des Rohres 2 eingesetzt werden, dass der äußere 13 oder der innere 12 Strömungsdes jeweiligen Mediums in diesem Bereich vergrößert wird. Das ist dann der Fall, wenn die TEM 3 an dieser Stelle bezogen zur Rohrwandung 2 inwärts 12 oder auswärts 13 zurücksteht.

Das Vor- oder Zurückstehen der Term 3 bezogen zur Rohrwandung 2 kann vorteilhaft sein, als dadurch Verwirbelungen in die Strömung indiziert werden, weil diese hierdurch in ihrem Verlauf beeinträchtigt wird.

Auch kann die Unter- oder Oberseite 12, 13 des TEM 3 mit der Rohrwandung 2 bündig sein.

Zusammenfassend kann festgehalten werden, dass die TEM 13 beispielsweise über deren seitliche Außenkontur (seitlicher Umfang 27) und/oder über deren peripheren Bereiche der Ober- und Unterseite 12, 13 mit dem Rohr 2 oder einem Fügeblech 4 verbunden ist, während der komplette oder zumindest überwiegend mittlere Bereich der Ober- und Unterseite 12, 13 dem direkten Kontakt der strömenden Medien ausgesetzt wird, Desweiteren können die TEM 3 im Rohr 2 vor- oder zurückstehen oder mit der Wandung 2 unter-oder Oberseite 12, 13 bündig sein.

Bezüglich des Bodens 5 lässt sich folgendes anmerken: Der Boden 5 trennt die beiden Stoffströme Medien an der Stirnseite der Warmeübertragungsstrecke 11, also an dessen Ein- und Austritt, und somit in axialer Richtung 9.

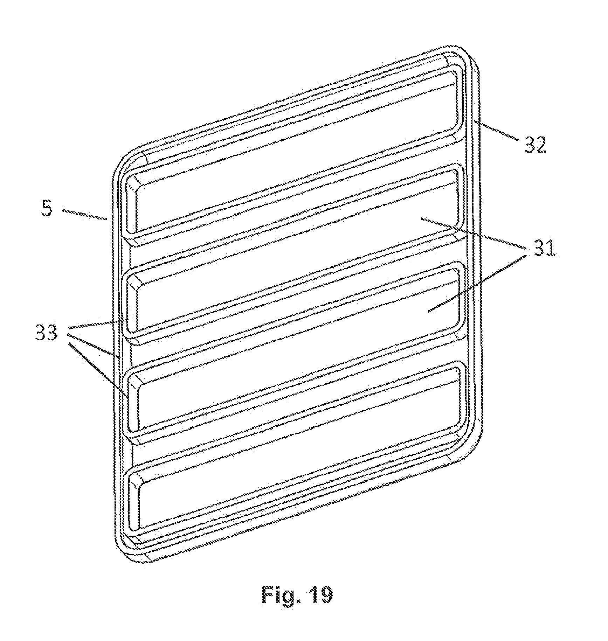

Der Boden 5 besteht beispielsweise aus einem umgeformten Blech (z.B. aus Edelstahl), beispielsweise entsprechend der Darstellung aus Fig. 19. Er ist günstigerweise mit einer Vielzahl an Aussparungen 31 ausgestattet, die in ihrer Anzahl, Anordnung und Form den Rohren 2 entsprechen, welche mit den Aussparungen 31 des Bodens 5 verbunden werden (z.B. durch Laser-Schweißen), Dazu werden die Rohre 2 zuvor in die Aussparungen 31 des Bodens 5 gesteckt. Es wird beispielsweise jeweils ein Boden 5 am Rohr-Ein- und Austritt 2 angefügt. Die Aussparungen 31 und die umfängliche Außenkontur 32 des Bodens 5 können mit Durchzügen 33 versehen werden. Die umfängliche Kontur 32 wird mit dem Gehäuse 6 und/oder dem Diffusor 7 verbunden z.B. Laser-Schweißen.

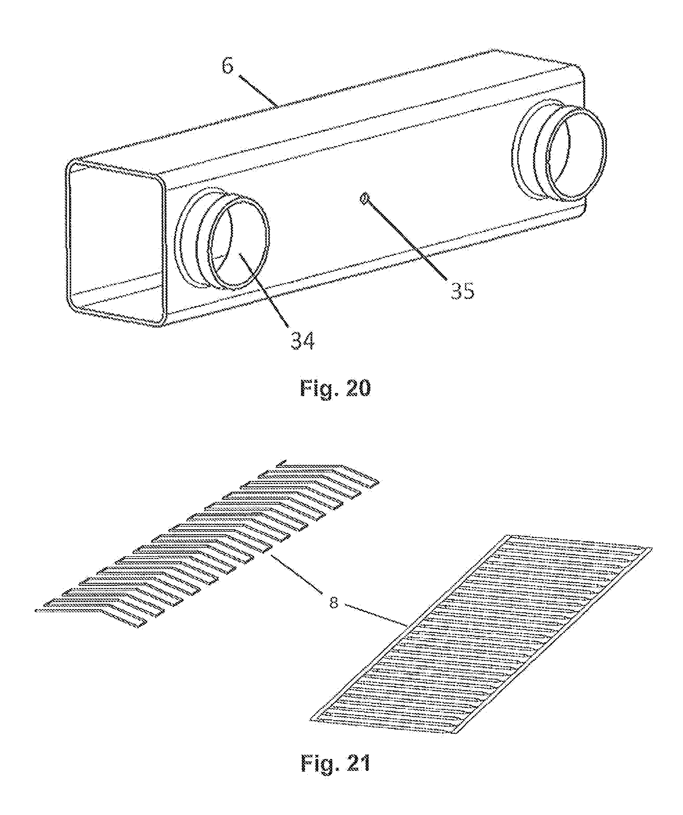

Bezüglich des Gehäuses 6 lässt sich folgendes anmerken: Das Gehäuse 6 ist bezüglich seiner Form beispielsweise ein rundes oder vieleckiges Rohr mit entsprechend großem Durchmesser (siehe Fig. 20). Das Gehäuse 6 kann in axialer Richtung 9 mehrfach abgesetzt sein, Zwischen der Außenseite der Rohre 13, 2 und der Innenseite des Gehäuses 13, 6 wird eines der Medien entlang der Warmeübertragungsstrecke 11 geführt, bevorzugt das kalte. Das Gehäuse 6 trennt somit diesen Stoffstrom radial 10 entlang der Warmeübertragungsstrecke 11 von der umgebenden Atmosphäre. Eine dem Gehäuse 6 vor- und nachgeschaltete Sammlung dieses Stoffstromes ist folglich nicht notwendig. Das Gehäuse 6 ist radial 10 und in der Nähe der axialen 9 Enden jeweils mit einer Öffnung 34 ausgestattet. Diese Öffnung 34 kann mit einem Durchzug versehen werden, Die Öffnungen 34 sind mit Anschlussleitungen verbunden. Über die Öffnungen 34 wird bevorzugt das kalte Medium in das Gehäuse 6 hinein- bzw. hinausgeleitet. Die Enden in axiale Richtung 9 des Gehäuses 6 werden über dessen lnnen- oder Außendurchmesser mit den Böden 5 oder mit den Diffusoren 7 verbunden (z.B. durch Laser-Schweißen).

In radiale Richtung 10 wird eine weitere kleine Öffnung 35 im Gehäuse 6 vorgesehen, durch die das oder die Elektrokabel 15 der TEM 3 geführt werden kann. Die Öffnung 35 sollte entsprechend abgedichtet sein (z.B. mittels Kleber).

Bezüglich des Diffusors 7 lässt sich folgendes ausführen. Der Diffusor 7 besteht beispielsweise aus einem umgeformten und/oder geschweißten Blech, Er hat beispielsweise zwei Öffnungen, Auf der einen Seite (erste Öffnung) ist der Diffusor mit einer Anschlussleitung verbunden, auf der anderen Seite (zweite Öffnung) mit dem Boden 5 und/oder mit dem Gehäuse 6. Die Öffnungen unterscheiden sich naturgemäß und im Allgemeinen in ihrem Durchmesser. Der Diffusor ist strömungstechnisch in vorteilhafter Weise gestaltet. Der Raum zwischen Dlffusor-Innenwand 7 und Boden 5 bildet eine Kammer, welcher das Medium, dass mit den Rohren 2 kommuniziert, vor Ein- und nach Austritt Sammelt. Demgemäß werden zwei Diffusoren 7 je TEG 1 vorgesehen.

Bezüglich einer Turbulenzeinlage 8 lässt sich folgendes anmerken: Um den Wärmeübergang im TEG 1 Rohr-innen 2, 12 - und/oder Rohr-außenseitig 2, 13 zu erhöhen, und dadurch die wirksamen Wandtemperatur-Differzen zwischen Medium 1 und Medium 2 zu steigern, kann es vorteilhaft sein, in die Strömungen zusätzlich turbulenzsteigernde Einlagen 8 einzubringen, wie sie beispielhaft in Fig. 21 dargestellt sind. Diese Einlagen 8 können beispielsweise gestanzte Bleche sein, die Rippen-artig oder Winglet-artig beschnitten, geformt oder strukturiert sind. Diese Rippen können in vorteilhafter Weise verdreht, also nach oben gebogen sein. Auch ein vielfach gebogener oder spiralförmiger Draht oder ein in sich verdrehtes Blech kann zu diesem Zwecke herangezogen werden, Die Turbulenzeinlage 8 wird in die Rohre 2 und/oder zwischen die Rohre 2 eingesteckt. Sie kann mit beliebiger Komponente im TEG 1 stoff-, form-, oder kraftschlüssig verbunden sein, oder auch nur lose eingebracht sein.

Auch können alternative Ausführungen der Erfindung vorgesehen sein:

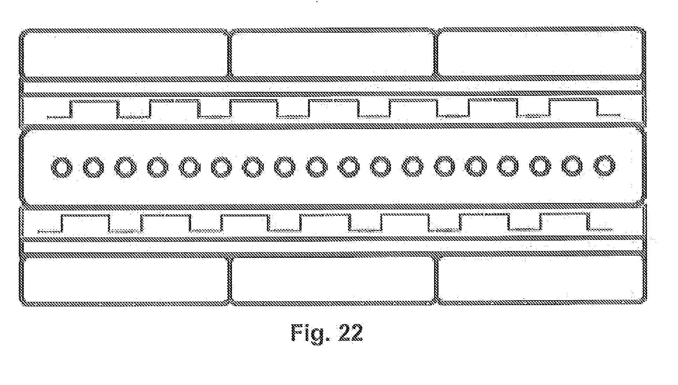

Eine erste Alternative kann sich dadurch auszeichnen, dass es sich hierbei nicht um einen Rohrbündel-Wärmeübertrager handelt. Die Medien werden im Gleich- oder Parallelstrom geführt Fig. 22 zeigt eine Querschnittansicht der ersten alternativen Ausführungsform der Erfindung.

Das erste Medium wird in einem oder mehreren Rohren geführt, die nebeneinander angeordnet sind. Das zweite Medium wird in einem oder mehreren Rohren geführt, die nebeneinander angeordnet sind, Welche beispielsweise eine Vielzahl an Kanälen aufweisen können. Der Rohr-Verbund für das erste Medium und der Rohr-Verbund für das zweite Medium werden ühereinadergelegt, wobei dazwischen noch eine Lage mit TEM eingebracht wird, Zwischen den TEM und den Rohren kann noch ein Blech eingebracht werden. TEM und Rohre, bzw. TEM und Bleche können miteinander geklebt oder stöffschlüssig verbunden sein.

Dieser Aufbau kann beliebig häufig geschichtet werden, sodass sowohl das erste als auch das zweite Medium auf mehrere Lagen verteilt wird.

Die den Medien zugeordneten Rohre werden im Ein- und Austritt jeweils an Leitungen angeschlossen. Diese Leitungen werden jeweils in Hauptleitungen zusammengeführt.

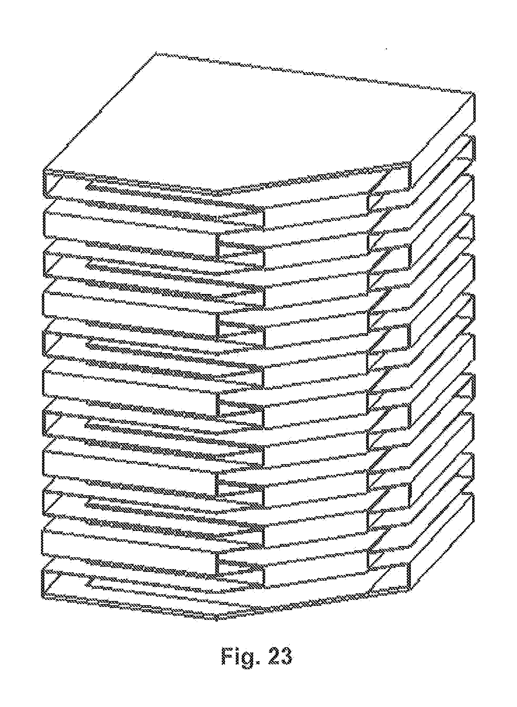

Eine zweite alternative Ausführungsform der Erfindung ist in Fig. 23 in isometrischer schnittdzrstelllung wiedergegeben, Hierbei handelt es sich nicht um einen Rohrbündel-Wärmeübertrager. Die Medien werden im Kreuzstrom geführt

Die Rohre für das erste Medium entsprechen den vorstehenden Beschreibungen für das erste Ausführungsbeispiel bezüglich der Figuren 8 -18. Das zweite Medium wird ebenfalls in Rohren geführt, welche auch den Beschreibungen zu den Figuren 8 - 18 entsprechen können. Die TEM sind auf einer Seite in die Öffnungen der Rohre für das erste Medium eingelassen bzw. ein/aufgesetzt, und auf der anderen Seite in die Öffnungen der Rohre für das zweite Medium. Die Fügemechanismen und Verbindungsformen von TEM-Rohr entsprechen in beiden Fällen beispielsweise den bezüglich den Figuren 8 bis 18 beschriebenen Verbindungsmechanismen. Somit sind die TEM beidseitig oben und unten an zwei unterschiedliche Rohre gebunden, und nicht wie vorstehend nur an eines auf einer Seite.

Dieser Aufbau kann beliebig häufig geschichtet werden, sodass sowohl das erste als auch das zweite auf mehrere Lagen verteilt wird.

Die Elektrokabel werden seitlich der TEM in der umgebenden Atmosphäre herausgeführt.

Da hier das zweite Medium in Rohren geführt wird, und nicht wie bezüglich der Beschreibung der Figuren 8 bis 18 im Gehäuse strömt, entfällt die Notwendigkeit eines Gehäuses. Stattdessen sind vier Böden und vier Diffusoren erforderlich, um die ersten und zweiten Medien jeweils im Ein- und Austritt zu sammeln,

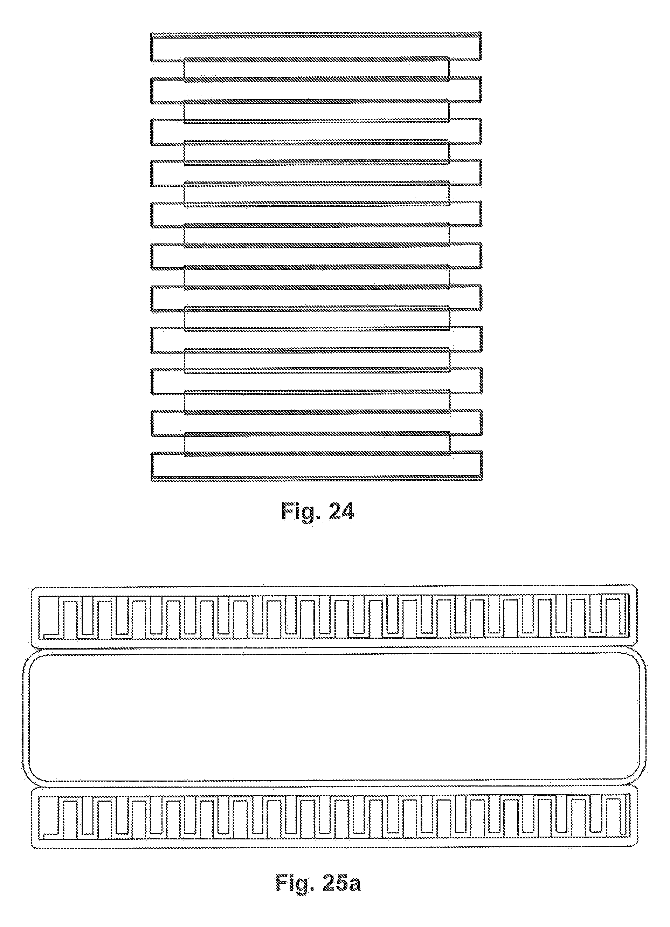

Der Aufbau eines dritten alternativen Ausführungsbeispiels der Erfindung ist in Fig. 24 beschrieben. Dieser Aufbau entspricht dem Aufbau des zweiten alternativen Ausführ5ungsbeispiels, wobei die Medien allerdings nicht im Kreuzstrom geführt werden, sondern im Gleich- oder Parallelstrom geführt werden.

Es sind zwei Boden und zwei Diffusoren vorgesehen, um eines der Medien im Ein- und Austritt zu sammeln. Das anderen Medium kann nicht auf diese Weise gesammelt werden. Die diesem Medium zugeordneten Rohre werden im Ein- und Austritt an Leitungen angeschlossen. Diese Leitungen werden in einer Hauptleitung zusammengeführt.

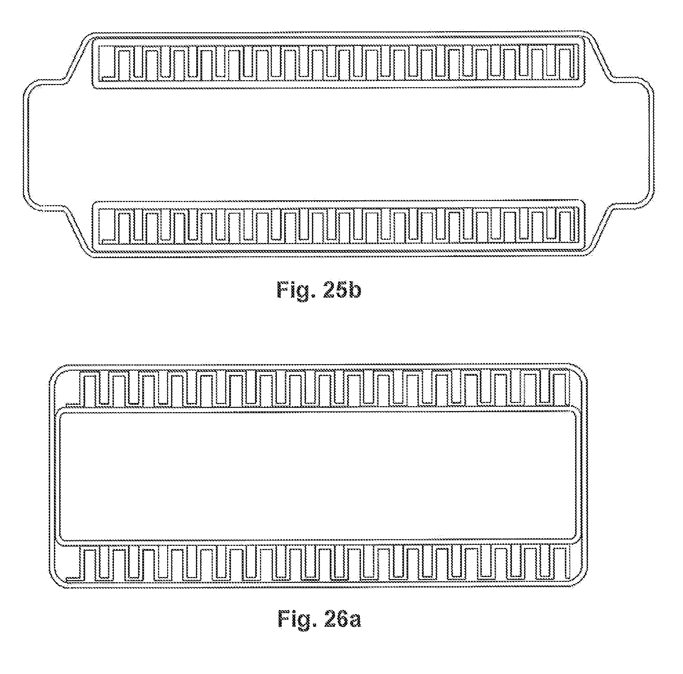

In Fig. 25a und 25b sind zwei Ausführungsformen gemäß einem vierten alternativen Ausführungsbeispiel der Erfindung dargestellt In diesen Ausführungsformen sind die Rohre im Wesentlichen entsprechend den Figuren 8 bis 18 aufgebaut, allerdings sind die Rohre nicht mit Öffnungen ausgestattet. Die TEM werden auf der Innen- oder Außenseite der Rohre aufgebracht, wodurch die Ober- oder Unterseite der TEM mit den Rohren verbunden ist. Das Rohr kann im Bereich der Verbindungsstelle TEM-Rohr nach innen oder außen verformt/gewölbt sein.

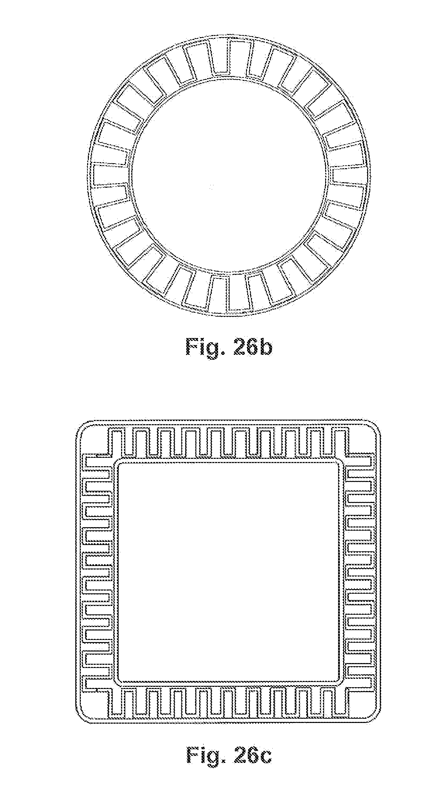

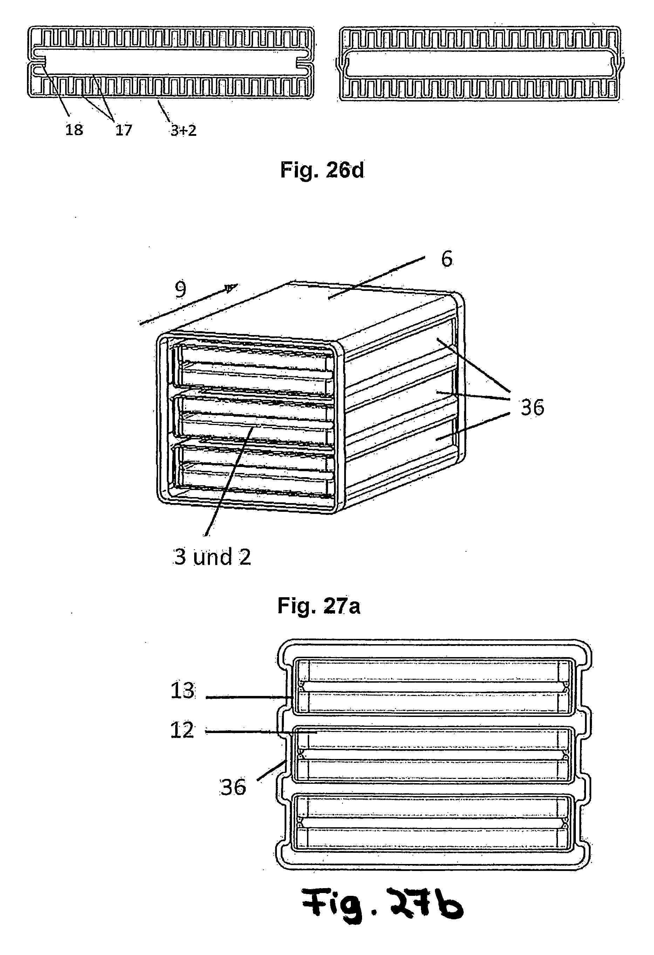

In den Figuren 26a bis 26c sind Ausführungsformen gemäß einem fünften alternativen Ausführungsbeispiel der vorliegenden Erfindung dargestellt, In diesen Ausführungsformen sind die Rohre wiederum im Wesentlichen entsprechend der Figuren 8 bis 18 ausgestaltet, jedoch sind die Rohre allerdings nicht mit Öffnungen ausgestattet. Außerdem umfasst die Wandung der Rohre ein zwei-schaliges Doppelrohr. Das Rohr besitzt also eine doppelte Wand/Hülle, eine innenliegende Hülle und eine außenliegende Hülle. Das thermoelektrisch aktive Material ist in der Wand, und somit zwischen innenliegende Hülle und eine außenliegende Hülle eingebracht. Die Rohrwandung bildet dadurch gleichzeitig den Hüllkörper des TEM. Das Rohr kann keramisch oder metallisch sein. Diese Alternative stellt eine Kombination eines Rohres und des TEM dar. Dabei kann sowohl die innenliegende Hülle als auch die außenliegende Hülle jeweils ein- oder mehrteilig ausgeführt werden, wie dies beispielhaft in den Darstellungen aus Fig. 26 abgebildet ist.

In weiteres Ausführungsbeispiel eines Gehäuses 6 ist in Fig. 27a dargestellt, in der das Gehäuse mit Einprägungen 36 versehen ist, wobei im Rohr 2 ein heißes Gas (Abgas auf dessen Innenseite 12) strömt und an der Innenseite 13 des Gehäuses 6, d.h. auf der Außenseite 13 des Rohres 2 das Kühlmittel strömt. Die Einprägungen 36 im Gehäuse 6 sorgen dafür, dass im seitlichen Bereich der Rohre 2 auf der Außenseite 13 kein oder wenig Kühlmittel strömt. Dies ist vorteilhaft, wenn im seitlichen Bereich der Rohre (2) auf der Innenseite 12 kleine TEM 3 angebracht sind. In Fig. 27b ist eine Vorderansicht eines solchen Aufbaus dargestellt.

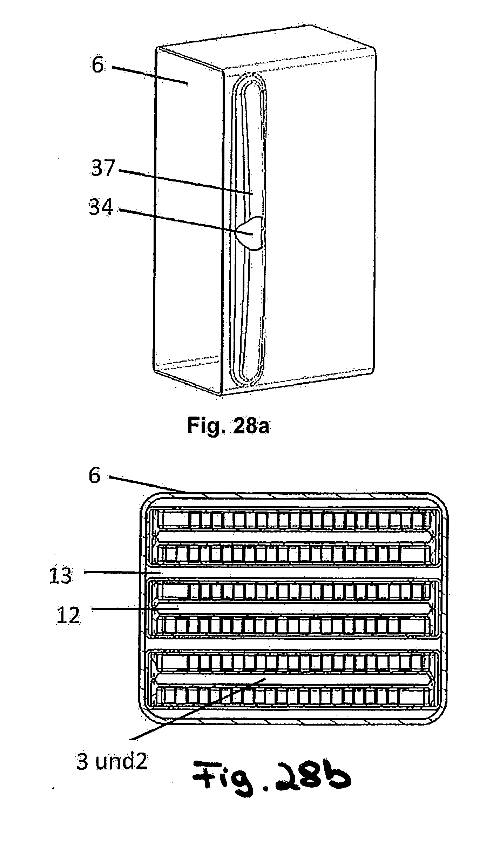

Ein weiteres Ausführungsbeispiel der vorliegenden Erfindung ist in der Fig. 28a dargestellt Die Verteiler-Ausprägungen 37 im Gehäuse 6 dieser Ausführungsform sorgen dafür, dass das Kühlmittel auf der Außenseite 13 im Ein- und Austrittsbereich 34 zwischen die Rohre 2 geführt werden kann. Dies ist insbesondere dann notwendig, wenn das Gehäuse 6 entlang der axialen Warmeubertragungsstrecke 9 im seitlichen Bereich der Rohre 2 anliegt, und somit kein oder wenig Kühlmittel strömen kann. Fig. 28b zeigt eine Querschnittansicht eines derartigen Ausführungsbeispiels.

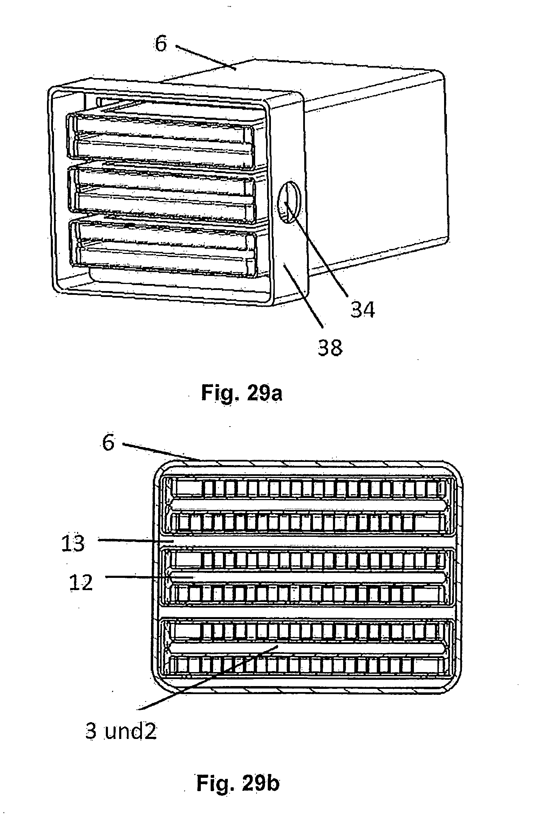

Alternativ zu der in Fig. 27 dargestellten Ausführungsform für ein Gehäuse kann die Zu- und Abführung des Kühlmittels 13 auch dadurch bewerkstelligt werden, dass das Gehäuse 6 im Anfangs- und Endbereich aufgeweitet 38 wird, sodass das Kühlmittel auf der Außenseite 13 im Ein- und Austrittsbereich 34 zwischen die Rohre 2 geführt werden kann. Eine solche Ausführungsform ist in der Fig. 29a in isometrischer Ansicht und in der Fig. 29b in einer Querschnittansicht dargestellt.

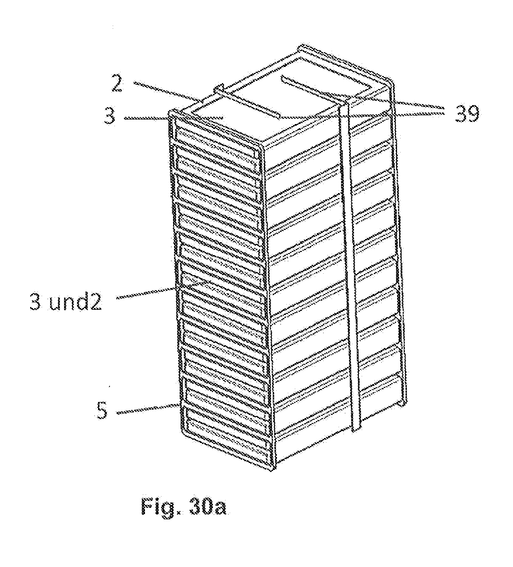

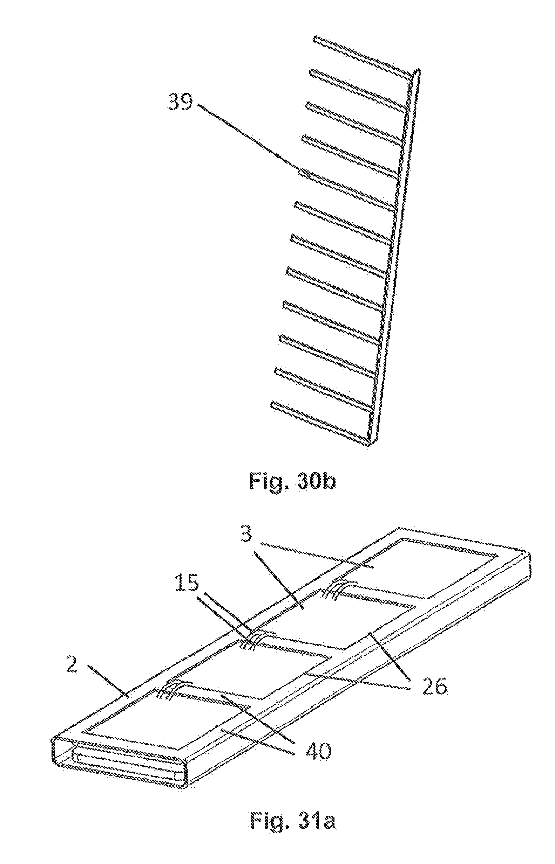

Vor allem bei sehr hohen und sehr kurzen 9 TEGs 1 kann es vorteilhaft sein Umlenkungen 39 auf der Außenseite 13 einzubringen. Dadurch wird eine gleichmäßigere Massenstromdichte gewährleistet und die Rohre 2/ TEM 3 über einen größeren Bereich mit strömendem Medium 13 beaufschlagt, denn Totwassergebiete können somit minimiert werden. Außerdem wird die wärmeaustauschende Länge erhöht. Die Umlenkungen 39 Können gestanzte und gebogene Bleche sein, die mit den Rohren 2 teilweise verbunden sind. In Fig. 30a ist eine isometrische Außenansicht eines solchen Ausführungsbeispiels dargestellt. In Fig. 30b ist eine isometrische Ansicht eine möglicherweise verwendbaren Umlenkung 39 für den vorstehend genannten Zweck darstellt.

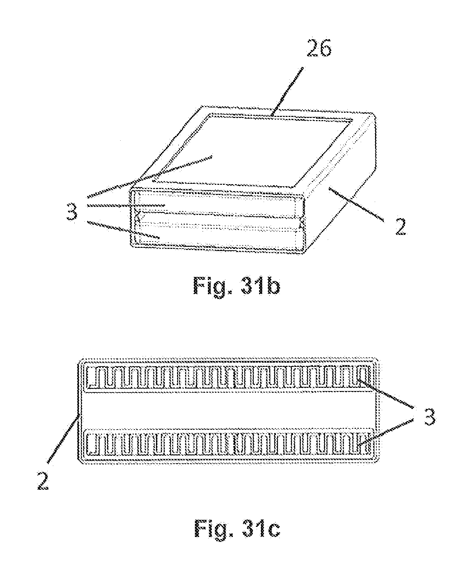

Um die Temperaturdifferenz entlang der Wärmaustauschfiäche 9 möglichst hoch zu halten, und somit die Effizienz des TEG 1 zu steigern, ist es vorteilhaft die TEM 3 so auszuführen und anzuordnen, dass die Rohre 2 möglichst großflächig mit TEM 3 belegt sind. Dazu werden die TEM 3 beispielsweise entsprechend der isometrischen Darstellung aus Fig. 31a oder 31b entweder nacheinander 9 berührend oder zumindest sehr dicht folgend angeordnet. Außerdem werden die TEM 3 möglichst breit 20 ausgeführt (der Breite des Rohres 2 entsprechend). Zudem kann es vorteilhaft sein, in Längsrichtung 9 nur ein TEM 3 anzuordnen, dies dafür aber möglichst lang 19 auszuführen. Fig. 31c zeigt eine Querschnittsdarstellung eines solchen Ausführungsbeispiels.

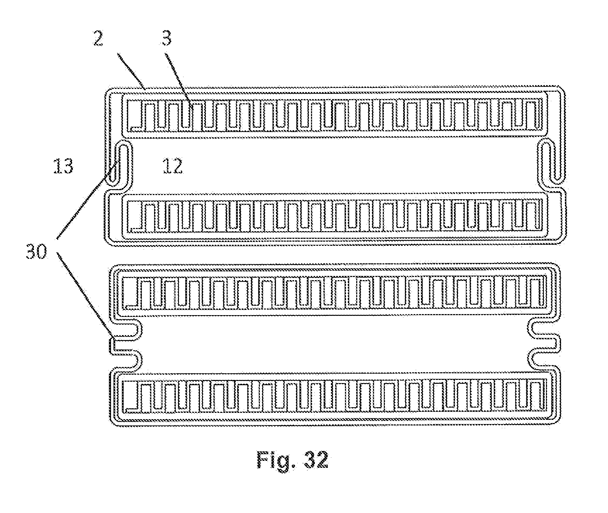

Auch können die Rohre 2 im mittleren, seitlichen Bereich zwischen zwei TEM 3 mit einer Faltung 30 ausgeführt werden, wie dies beispielsweise gemäß der Darstellungen aus Fig. 32 gezeigt ist. Dies ermöglicht erstens eine thermische Trennung zwischen der Innenseite 12 und einer Außenseite 13 des Rohres, wobei zweitens der Wellbalg als ein thermisches, thermo-mechanisches und mechanisches Kompensationselement wirken kann.

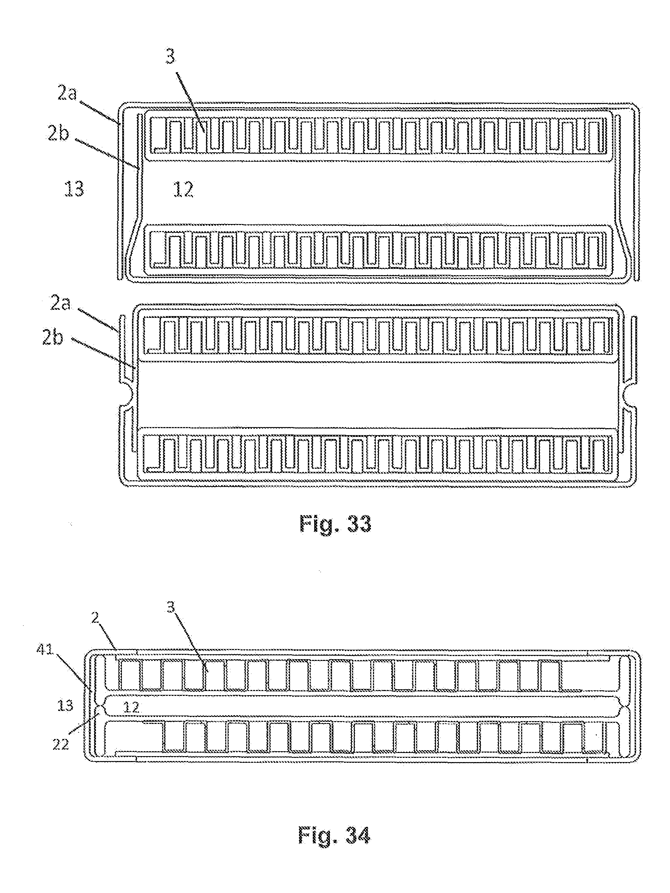

Auch können gemäß den Darstellungen gemäß Fig. 33 die Rohre 2 zweiteilig 2a, b ausgeführt und im mittleren, seitlichen Bereich verbunden (beispielsweise mittels Laserschweißen) werden. Die beiden Teile 2a, b können so gestaltet sein, dass im Bereich der Verbindungsstelle eine thermische Trennung zwischen der Rohrinnenseite 12 und der Rohraußenseite 13 gebildet wird,

In einem weiteren Ausführungsbeispiel, das in Fig. 34 dargestellt ist, werden die TEM 3 werden im seitlichen Bereich 27 in der Breite 20 mit einer Erhöhung im Randbereich 22 ausgeführt. Diese Erhöhung 22 ist so gestaltet, dass sich das obere TEM 3 im Rohr 2 und das untere TEM 3 im Rohr 2 näherungsweise berühren. Zudem kann die Breite 20 der TEM 3 etwas kleiner sein, als die Breite des Rohres 20 auf der Innenseite 12, sodass sich ein Spalt 41 zwischen Rohr 2 und TEM 3 bildet. Durch diese Maßnahmen kann im seitlichen Bereich des Rohres 2 der Wärmeaustausch zwischen 13 und 12 reduziert werden,

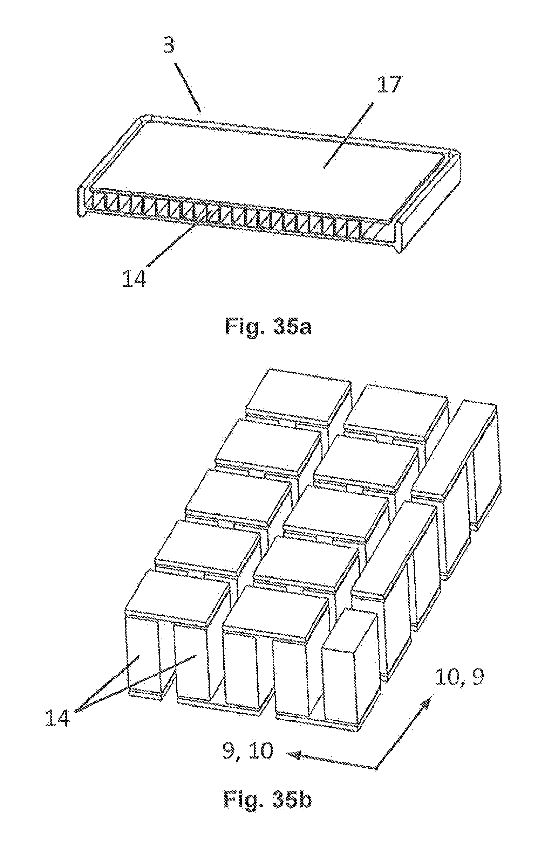

Ferner ist anzumerken, dass die Ausrichtung der TE-aktiven Materialien 14 im TEM 3 ist bei allen Ausführungen beliebig ist, Dabei kann die Anordnung der TE-aktiven Materialien 14 sowohl in axiale 9 als auch in radiale Richtung 10 weisen. Zudem ist die Anzahl der TE-aktiven Materialien 14 in axiale 9 und radiale 19 Richtung beliebig. Ausführungsbeispiele für eine solche, Ausrichtung der TE-aktiven Materialien sind in Fig. 35a und 35b dargestellt.

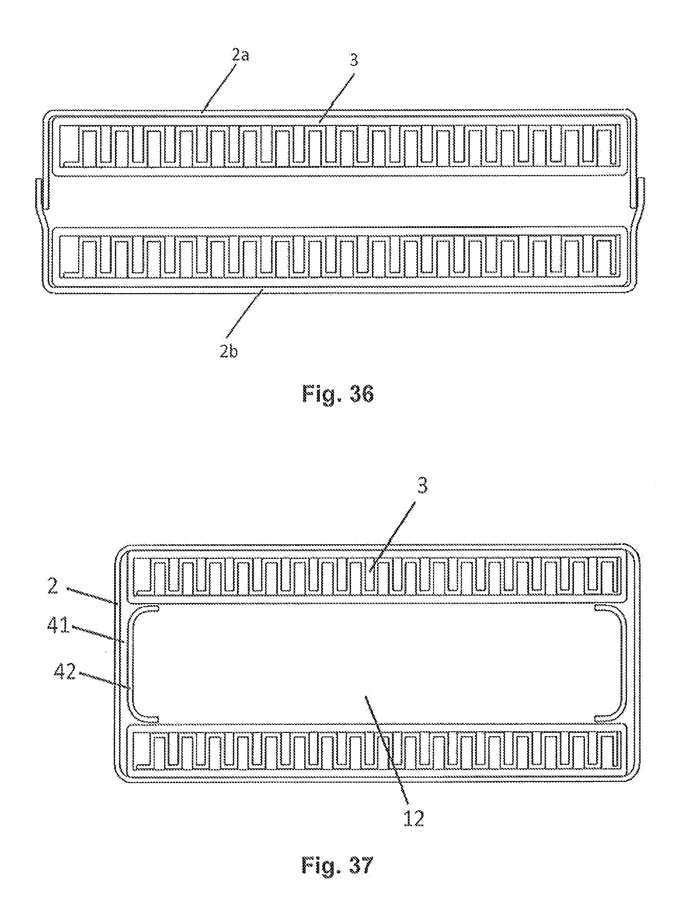

Auch kann das Rohr 2 mehrteilig ausgeführt werden, wie dies in Fig. 36 dargestellt ist.

Im seitlichen Bereich des Rohres 2 kann dieses zwecks thermischer Trennung zwei-schalig aufgebaut sein. Diese Seitenschalung 42 kann im Bereich der Enden des Rohres 2 mit dem Rohr 2 verbunden sein, sodass kein oder wenig innenseitiges 12 Medium in den Spalt 41 einströmt. Ein derartiges Ausführungsbeispiel ist in Fig. 37 dargestellt,

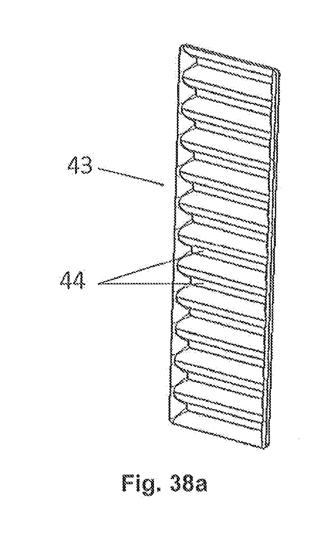

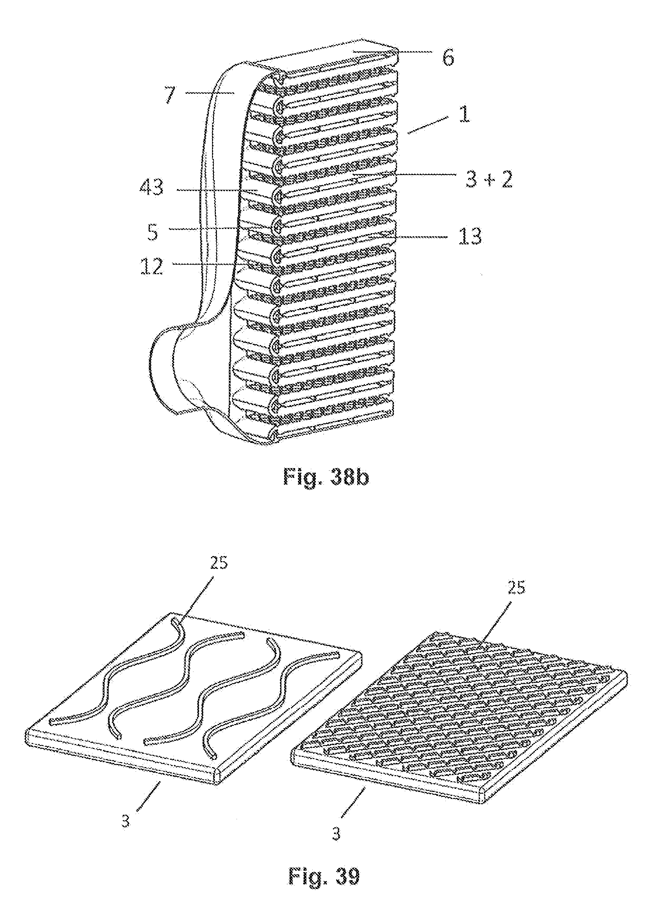

Auch kann gemäß einem weiteren Ausführungsbeispiel die Vorsatzschale, 43 beispielsweise ein umgeformtes Blech sein und vor dem Boden 5 im Diffusor 7 platziert werden. Entsprechend den Aussparungen im Boden 31 können dann auch Aussparungen in der Vorsatzschale 44 vorgesehen sein. Der Bereich zwischen den Aussparungen 44 kann in vorteilhafter Weise so geformt/gebogen sein, dass das strömende Medium ausgehend vom Diffusor 7 mit geringen zusätzlichen Druckabfällen in den Rohr-TEM-Block 2, 3 geleitet wird 12. Die Vorsatzschale 43 kann mit dem Diffusor 7, Gehäuse 6, Boden 5, TEM 3 oder Rohr 2 teilweise verbunden sein. Bevorzugt ist die Vorsatzschale 43 partiell mit dem Gehäuse 6 verbunden. Somit werden Boden 5 und Rohr 2 und gegebenenfalls auch die Verbindung zwischen Rohr 2 und TEM 3 vor hohen Temperaturdiffereizen und daraus resultierenden Thermospannungen weitgehend geschützt, wenn hierbei auf der Außenseite 13 das kalte Medium geführt wird. Fig. 38a zeigt eine isometrische Darstellung einer Vorsatzschale. Fig. 38b zeigt einen TEG 1 isometrisch im Längsschnitt.

Das TEM 3 kann auch entsprechend den beispielhaften Darstellungen der Fig. 39 profiliert 25 sein.

### Bezugszeichenliste

- 1: Thermoelektrischer Generator TEG
- 2: Rohr
- 3: Thermoelekrinsches Modul TEM
- 4: Fügeblech
- 5: Boden
- 6: Gehäuse
- 7: Diffusor
- 8: Turbulenzetnlage
- 9: Axiale Richtung
- 10: Radiale Richtung
- 11: Warmeübertragungsstrecke
- 12: Innenseite: Medium 1
- 13: Außenseite: Medium 2
- 14: thermoelektrisch (TE) aktive Materialien
- 15: Elektro-Kabel
- 16: Innere des TEM
- 17: Hüllkörper des TEM
- 18: Abdichtung des TEM
- 19: Länge TEM
- 20: Breite TEM
- 21: Höhe TEM
- 22: Erhöhung im Randbereich des TEM
- 23: Durchzüge dies Rohres
- 24: Absatz im Randbereich des TEM
- 25: Profilierung des TEM
- 26: Öffnungen im Rohr
- 27: seitliche Bereiche des TEM
- 28: Kragen: gebogener Durchzug
- 29: Sicke im Durchzug
- 30: Faltung im Blech
- 31: Aussparungen im Boden
- 32: Außenkontur des Bodens
- 33: Durchzüge im Boden
- 34: Öffnung im Gehäuse für Anschlussleitungen
- 35: Öffnung im Gehäuse für Elektro-Katbel
- 36: Einprägung im Gehäuse
- 37: Verteiler-Ausprägungen im Gehäuse
- 38: Aufweitungen im Anfangs- und Endbereich des Gehäuses
- 39: Umlenkungen
- 40: Verbindungsfläche Rohr mit TEM
- 41: Spalt zwischen TEM und Rohr auf der Innenseite
- 42: Seitenschalung
- 43: Vorsatzschale
- 44: Aussparungen in der Vorsatzschale

## Patentansprüche

1. Thermoeiektrische Vorrichtung (1) zur Erzeugung von elektrischer Energie aus Wärme, wobei die Vorrichtung (1) die folgenden Merkmale umfasst:
- ein thermoelektrisches Modul (3), das eine erste Hauptoberfläche (12, 13) und eine der ersten Hauptoberfläche (12, 13) gegenüberliegende zweite Hauptoberfläche (12, 13) aufweist, wobei das thermoeiektrische Modul (3) eine Mehrzahl von Elementen (14) mit einem thermoelektrisch aktiven Material aufweist, die sich im Wesentlichen senkrecht zwischen der ersten und der zweiten Hauptoberfläche (12, 13) des therimoelektrischen Moduls (3) erstrecken und die ferner ausgebildet sind, um bei einem thermischem Kontakt mit Medien unterschiedlicher Temperatur eine elektrische Energie und
- eine Haltestruktur (2, 4, 5, 6, 7), die zur Führung eines warmen und eines kalten Mediums und zur Halterung des thermoelektrischen Moduls (3) ausgebildet ist, wobei die Haltestruktur (2, 4, 5, 6, 7) ferner ausgebildet ist, um das kalte Medium derart zu führen, dass es in thermischen Kontakt mit der ersten Hauptobetrfläche (12, 13) tritt und das warme Medium derart zu führen, dass es in thermischen Kontakt mit der zweiten Hauptoberfläche (12, 13) tritt.

2. Thermoelektrische Vorrichtung (1) gemäß Anspruch 1, **dadurch gekennzeichnet, dass das** thermoelektrische Modul (3) einen Hüllkörper (17) umfasst, der ausgebildet ist, um die Elemente (14) aus dem thermoelektrischen Material gegen Einflüsse oder Verunreinigungen , insbesondere fluidische Verunreinigungen, von außerhalb des thermoelektrische Moduls (3) zu schützen, wobei die erste und zweite Hauptoberfläche (12, 13) des thermoeiektrischen Moduls (3) durch Flächen des Hüllkörpers (17) gebildet werden.

3. Thermoelektrische Vorrichtung (1) gemäß einem der vorhergehenden Ansprüche, **dadurch gekennzeichnet, dass** das thermoelektrische Modul (3) zumindest ein Anschlusselement (22, 24) aufweist, das von einer Oberfläche des thermoelektrischen Moduls (3) absteht und das ausgebildet ist, um eine mechanische Verbindung zwischen dem thermoelektrischen Modul (3) und der Haltestruktur (2, 4, 5, 6, 7) zu verbessern.

4. Thermoeiektnsche Vorrichtung (1) gemäß einem der vorhergehenden Ansprüche, **dadurch gekennzeichnet dass** die erste und/oder zweite Hauptoberfläche (12, 13) eine Profilierung (25) ausweist

5. Thermoelektrische Vorrichtung (1) gemäß einem der vorhergehenden Ansprüche, **dadurch gekennzeichnet, dass** die Haltestruktur (2, 4, 5, 6, 7) zumindest ein Rohr (2) aufweist, das zur Führung eines der Medien, insbesondere des warmen Mediums ausgebildet ist, wobei die erste oder zweite Hauptoberfläche (12, 13) des thermoelektrischen Moduls (3) mit dem Medium in dem Rohr (2) thermisch kontaktierbar ist.

6. Thermoelektrische Vorrichtung (1) gemäß Anspruch 5, **dadurch gekennzeichnet, dass** in des dem Rohr (2) oder um das Rohr (2) herum eine Turbulenzeinlage (8) angeordnet ist und/oder das das Rohr (2) an einer Außenseite und/oder an einer der Wand des Rohres (2) eine Profilierung aufweist.

7. Thermoelektrische Vorrichtung (1) gemäß Anspruch 5 oder 6, **dadurch gekennzeichnet, dass** das Rohr (2) zumindest eine Öffnung (26) aufweist, und wobei ein thermoelektrisches Modul (3) derart angeordnet ist, dass die Öffnung (26) im Wesentlichen durch das thermoelektrische Modul (3) verschlossen oder zumindest abgedeckt ist.

8. Thermoelekrische Vorrichtung (1) gesäß Anspruch 7, **dadurch gekennzeichnet, dass** das Rohr (2) ein Flachrohr (2) ist und die Breite der Öffnung (26) näherungsweise der Breite des Fachrohres (2) entspricht, insbesondere zumindest achtzig Prozent der Breite des Flachrohres (2) entspricht

9. Thermoelektrische Vorrichtung (1) gemäß Anspruch 8, **dadurch gekennzeichnet, dass** das Flachrohr (2) an zwei gegenüberliegenden größeren Seiten des Flachrohres zumindest je eine Öffnung (26) aufweisen, die durch je ein thermoelektrisches Modul (3) im Wesentlichen verschlossen oder zumindest abgedeckt sind.

10. Thermoelektrische Vorrichtung (1) gemäß einem der Ansprüche 5 bis 9, **dadurch gekennzeichnet, dass** das an dem Rohr (2) befestigte thermoelektrische Modul (3) einen Strömungsquerschnitt für ein in dem Rohr (2) oder ein um das Rohr (2) herum strömendes Medium vergrößert oder verkleinert.

11. Thermoelektrische Vorrichtung (1) gemäß einem der Anspruche 5 bis 10, **dadurch gekennzeichnet, dass** das Rohr (2) einen Durchzug (23), einen Kragen (28), eine Sicke (29) oder ein Fügeblech (4) zur Befestigung des thermoelektrischen Moduls (3) daran aufweist.

12. Thermoelektrische Vorrichtung (1) gemäß einem der Ansprüche 5 bis 11, **dadurch gekennzeichnet, dass** das Rohr (2) oder ein Fügeblech (4) zumindest eine Prägung, eine Faltung (30), eine Biegung oder eine Sicke (29) aufweist.

13. Thermoelektrische Vorrichtung (1) gemäß einem der Ansprüche 5 bis 12, **dadurch gekennzeichnet, dass** die Haltestruktur (2, 4, 5, 6, 7) ein Gehäuse (6) umfasst, wobei in dem Gehäuse (6) das zumindest eine Rohr (2) derart angeordnet ist, dass in dem Rohr (2) ein erstes Medium führbar ist und zwischen einer Außenwand des zumindest einen Rohres und einer innenwand des Gehäuses ein zweites Medium führbar ist.

14. Thermoelektrische Vorrichtung (1) gemäß Anspruch 13, **dadurch gekennzeichnet, dass** die Haltestruktur (2, 4, 5, 6, 7) ferner einen Diffusor (7) aufweist, der an dem Gehäuse (6) befestigt ist und der ausgebildet ist, um das in dem Rohr (2) führbare Medium zu sammeln und in das zumindest einzuleiten oder aus dem Rohr (2) auszuleiten.

15. Thermoelektrische Vorrichtung (1) gemäß einem der Ansprüche 5 bis 14, **dadurch gekennzeichnet, dass** die Haltestruktur (2, 4, 5, 6, 7) eine Umlenkung (39) aufweist, die ausgebildet ist, um einen Fluss des kalten Mediums an einer Wand des Rohres (2) umzulenken.
